# EUROPEAN PATENT APPLICATION

(11) **EP 4 636 486 A1**
(43) Date of publication of application: **22.10.2025**
(21) Application number: 23903444.0
(22) Date of filing: 08.12.2023
(51) Int. Cl.: G03F 7/11, G03F 7/20, H01L 21/027

(54) **COMPOSITION FOR FORMING RESIST UNDERLAYER FILM**

(30) Priority: 15.12.2022 JP 2022200258
(71) Applicant: Nissan Chemical Corporation, Tokyo 103-6119 (JP)
(72) Inventor: OGATA, Hiroto, Toyama-shi, Toyama 939-2792 (JP); TAMURA, Mamoru, Toyama-shi, Toyama 939-2792 (JP)
(74) Representative: Hoffmann Eitle
(86) International application number: PCT/JP2023/044049
(87) International publication number: WO 2024/128157

(57) **Abstract**

A resist underlayer film-forming composition, containing a polymer (A) having a boronic acid structure and a solvent (B).

## Description

### Technical Field

The present invention relates to a resist underlayer film-forming composition, a resist underlayer film, a laminate, a method for producing a semiconductor element, and a pattern forming method.

### Background Art

Conventionally, microfabrication by lithography using a resist composition has been performed in the production of a semiconductor device. The microfabrication is a processing method of forming microrelief corresponding to a photoresist pattern on a substrate surface by forming a thin film of a photoresist composition on a semiconductor substrate such as a silicon wafer, irradiating the thin film with an active ray such as an ultraviolet ray through a mask pattern on which a device pattern is drawn, developing the thin film, and etching the substrate using the obtained photoresist pattern as a protective film. In recent years, semiconductor devices have become more highly integrated, and also as the active ray to be used, in addition to an i-line (wavelength: 365 nm), a KrF excimer laser (wavelength: 248 nm), and an ArF excimer laser (wavelength: 193 nm) that have been conventionally used, practical application of EUV light (wavelength: 13.5 nm) or an electron beam (EB) has been studied for the most advanced microfabrication. Along with this, poor resist pattern formation due to an influence of a semiconductor substrate or the like becomes a major problem. Therefore, in order to solve this problem, a method of providing a resist underlayer film between a resist and a semiconductor substrate has been widely studied.

Patent Literature 1 discloses an underlayer film-forming composition for lithography containing a naphthalene ring having a halogen atom. Patent Literature 2 discloses a halogenated antireflection film. Patent Literature 3 discloses a resist underlayer film-forming composition.

### Citation List

### Patent Literature

Patent Literature 1: WO 2006/003850 A
Patent Literature 2: JP 2005-526270 A
Patent Literature 3: WO 2020/111068 A

### Summary of Invention

### Technical Problem

Examples of the characteristics required for a resist underlayer film include that no intermixing with a resist film formed on an upper layer occurs (the resist film is insoluble in a resist solvent), and a resist pattern can be formed with high sensitivity.

The present invention has been made in view of the above circumstances, and an object of the present invention is to provide a resist underlayer film-forming composition capable of forming a resist underlayer film on which a resist pattern can be formed with high sensitivity, and a resist underlayer film, a laminate, a method for producing a semiconductor element, and a pattern forming method using the resist underlayer film-forming composition.

### Solution to Problem

As a result of intensive studies to solve the above problem, the present inventors have found that the above problem can be solved, thereby completing the present invention having the following gist.

That is, the present invention includes the following aspects.
[1] A resist underlayer film-forming composition, containing a polymer (A) having a boronic acid structure and a solvent (B).
[2] The resist underlayer film-forming composition according to [1], wherein the boronic acid structure is an arylboronic acid structure.
[3] The resist underlayer film-forming composition according to [1] or [2], wherein the solvent (B) contains at least one type selected from a group consisting of an alkylene glycol monoalkyl ether and a monocarboxylic acid ester of an alkylene glycol monoalkyl ether.
[4] The resist underlayer film-forming composition according to any one of [1] to [3], further containing a crosslinking agent (C).
[5] The resist underlayer film-forming composition according to [4], wherein the crosslinking agent (C) is at least one type selected from a group consisting of an aminoplast crosslinking agent and a phenoplast crosslinking agent.
[6] The resist underlayer film-forming composition according to any one of [1] to [5], further containing a curing catalyst (D).
[7] A resist underlayer film, which is a cured product of the resist underlayer film-forming composition according to any one of [1] to [6].
[8] A laminate, including:
   a semiconductor substrate; and
   the resist underlayer film according to [7].
[9] A method for producing a semiconductor element, the method including steps of:
   forming a resist underlayer film on a semiconductor substrate using the resist underlayer film-forming composition according to any one of [1] to [6]; and
   forming a resist film on the resist underlayer film.
[10] A pattern forming method, including steps of:
   forming a resist underlayer film on a semiconductor substrate using the resist underlayer film-forming composition according to any one of [1] to [6];
   forming a resist film on the resist underlayer film;
   irradiating the resist film with light or an electron beam, and then developing the resist film to obtain a resist pattern; and
   etching the resist underlayer film using the resist pattern as a mask.

### Advantageous Effects of Invention

According to the present invention, it is possible to provide a resist underlayer film-forming composition capable of forming a resist underlayer film on which a resist pattern can be formed with high sensitivity, and a resist underlayer film, a laminate, a method for producing a semiconductor element, and a pattern forming method using the resist underlayer film-forming composition.

### Description of Embodiments

### (Resist underlayer film-forming composition)

The resist underlayer film-forming composition of the present invention contains a polymer (A) and a solvent (B).

The resist underlayer film-forming composition may contain a crosslinking agent (C), a curing catalyst (D), and the like.

The polymer (A) has a boronic acid structure.

When the polymer (A) has a boronic acid structure, a resist pattern can be formed with high sensitivity.

### <Polymer (A)>

The polymer (A) has a boronic acid structure.

The boronic acid structure is, for example, a structure represented by formula (B1) below.

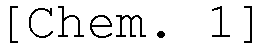

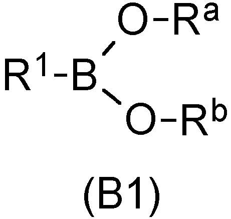

In formula (B1), R^{a} and R^{b} each independently represent a hydrogen atom, an alkyl group having 1 to 4 carbon atoms, a phenyl group, or a tolyl group. R^{a} and R^{b} may be combined together to form a ring structure having 3 to 6 carbon atoms.

R¹ represents a divalent or higher valent organic group.

R¹ is, for example, divalent or trivalent.

When R¹ is divalent, formula (B1) is represented by formula (B1-1) below.

When R¹ is trivalent, formula (B1) is represented by formula (B1-2) below.

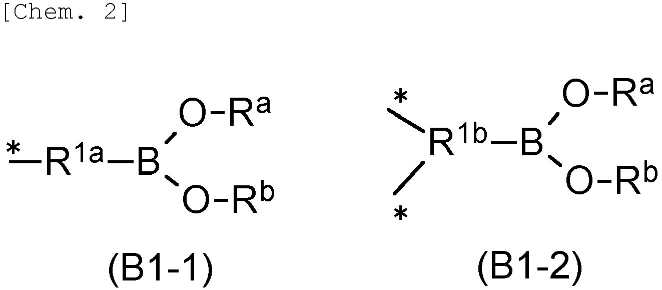

In formula (B1-1) and formula (B1-2), R^{a} and R^{b} each independently represent a hydrogen atom, an alkyl group having 1 to 4 carbon atoms, a phenyl group, or a tolyl group. R^{a} and R^{b} may be combined together to form a ring structure having 3 to 6 carbon atoms.

R^{1a} represents a divalent organic group.

R^{1b} represents a trivalent organic group.

* represents a bond.

The number of carbon atoms in R¹, R^{1a}, and R^{1b} is not particularly limited, but is preferably 1 to 10.

R¹, R^{1a}, and R^{1b} each may have, for example, a heteroatom. Examples of the heteroatom include an oxygen atom, a nitrogen atom, and a sulfur atom.

R¹, R^{1a}, and R^{1b} are, for example, a hydrocarbon group, preferably a hydrocarbon group having 1 to 10 carbon atoms.

The boronic acid structure is preferably an arylboronic acid structure from the viewpoint of suitably obtaining the effect of the present invention.

The arylboronic acid structure refers to a structure having an aromatic ring bonded to B (boron) among the boronic acid structures.

The arylboronic acid structure refers to, for example, a structure represented by formula (B1) when R¹ is a divalent or higher valent organic group having an aromatic ring bonded to B (boron) in formula (B1).

Examples of the aromatic ring include an aromatic hydrocarbon ring and an aromatic heterocyclic ring. Examples of the aromatic hydrocarbon ring include a benzene ring. Examples of the aromatic heterocyclic ring include a pyridine ring.

From the viewpoint of suitably obtaining the effect of the present invention, R¹ is preferably a group obtained by removing two or more hydrogen atoms from a benzene ring.

From the viewpoint of suitably obtaining the effect of the present invention, R^{1a} is preferably a divalent group (phenylene group) obtained by removing two hydrogen atoms from a benzene ring.

From the viewpoint of suitably obtaining the effect of the present invention, R^{1b} is preferably a trivalent group obtained by removing three hydrogen atoms from a benzene ring.

Examples of the boronic acid structure include the following structures.

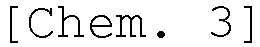

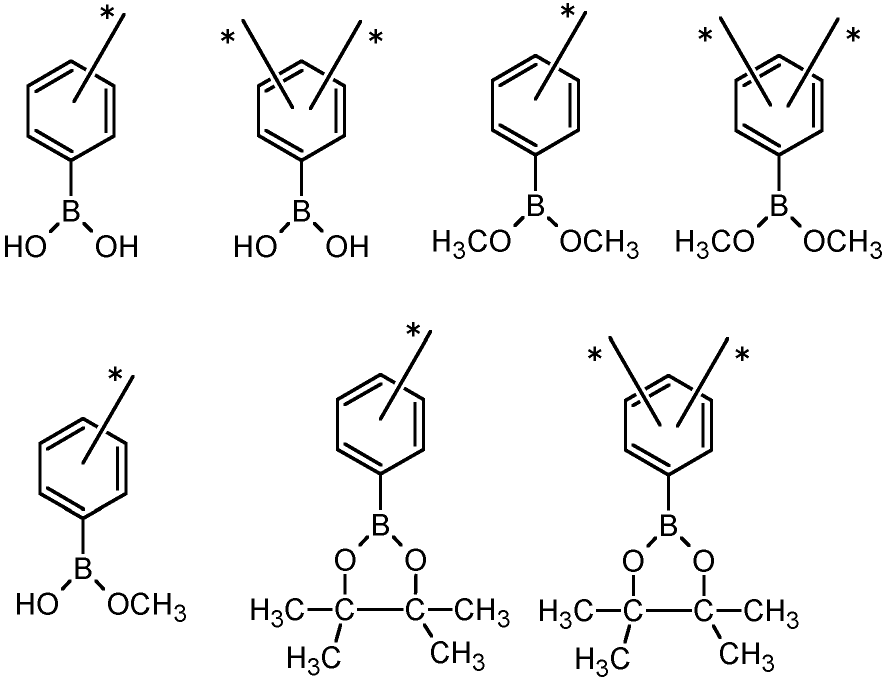

In the formulae, * represents a bond.

The polymer (A) has, for example, at least one or more types of unit structures, and at least one type of unit structure has a boronic acid structure.

The polymer (A) is, for example, an isocyanurate-based polymer. The isocyanurate-based polymer refers to a polymer having an isocyanurate skeleton.

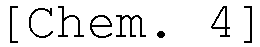

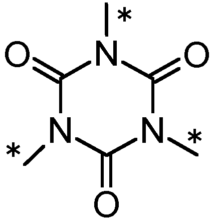

In the formula, * represents a bond.

One of the bonds represented by * may be bonded to a hydrogen atom.

The polymer (A) is, for example, a polyester-based polymer. The polyester-based polymer refers to a polymer having an ester bond at least in the main chain. The ester bond in the polyester-based polymer is formed, for example, by a reaction between a -CO-X group (X represents a hydroxy group, a halogen atom, or an alkoxy group having 1 to 4 carbon atoms) and a hydroxy group or an epoxy group.

When a polymer has an isocyanurate skeleton and has an ester bond in the main chain, the polymer is an isocyanurate-based polymer and is also a polyester-based polymer.

The polymer (A) is, for example, a vinyl-based polymer. The vinyl-based polymer is, for example, a polymer obtained by polymerizing a polymerizable unsaturated bond of a compound having a group with a polymerizable unsaturated bond. The vinyl-based polymer may be a homopolymer or a copolymer. Examples of the group having a polymerizable unsaturated bond include a (meth)acryloyl group, a vinylaryl group (for example, a styryl group), a vinyloxy group, and an allyl group.

The polymer (A) is, for example, a polymer having a hydroxy group in the unit structure. The hydroxy group is, for example, a hydroxy group bonded to a secondary carbon atom.

The polymer (A) is, for example, not a polymer having both an acetal structure and an amide bond.

The polymer (A) is, for example, not a polymer having an acetal structure.

The acetal structure refers to a structure in which the same carbon has two ether bonds.

The acetal structure is, for example, an acetal structure that protects two hydroxy groups adjacent to each other in an aromatic group.

The polymer (A) is, for example, not a polymer having both a structural unit including an alicyclic structure and a functional group bonded to a silicon atom-containing group.

The polymer (A) is, for example, not a polymer having both a structural unit including an alicyclic structure and a hydroxyboron-containing group bonded to a silicon atom-containing group.

The polymer (A) is, for example, not a polymer having a hydroxyboron-containing group bonded to a silicon atom-containing group.

Examples of the hydroxyboron-containing group include -B(OH)₂ and -B(R) (OH) (R represents a hydrocarbon group).

### <<Vinyl-based polymer (A1)>>

A case where the polymer (A) is a vinyl-based polymer (A1) will be described.

The vinyl-based polymer (A1) has, for example, a unit structure represented by formula (A1-1) below.

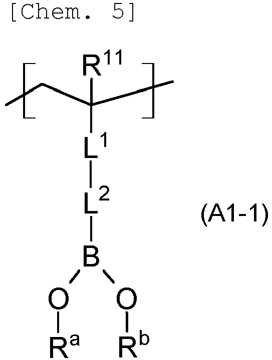

In formula (A1-1), R¹¹ represents a hydrogen atom or an alkyl group having 1 to 10 carbon atoms,
L¹ represents a single bond or a linking group,
L² represents a single bond or a divalent organic group,
R^{a} and R^{b} each independently represent a hydrogen atom, an alkyl group having 1 to 4 carbon atoms, a phenyl group, or a tolyl group, and R^{a} and R^{b} may be combined together to form a ring structure having 3 to 6 carbon atoms.

Examples of the alkyl group having 1 to 10 carbon atoms include a methyl group, an ethyl group, a n-propyl group, an i-propyl group, a cyclopropyl group, a n-butyl group, an i-butyl group, a s-butyl group, a t-butyl group, a cyclobutyl group, a 1-methyl-cyclopropyl group, a 2-methyl-cyclopropyl group, a n-pentyl group, a 1-methyl-n-butyl group, a 2-methyl-n-butyl group, a 3-methyl-n-butyl group, a 1,1-dimethyl-n-propyl group, 1,2-dimethyl-n-propyl group, a 2,2-dimethyl-n-propyl group, a 1-ethyl-n-propyl group, a cyclopentyl group, a 1-methyl-cyclobutyl group, a 2-methyl-cyclobutyl group, a 3-methyl-cyclobutyl group, a 1,2-dimethyl-cyclopropyl group, a 2,3-dimethyl-cyclopropyl group, a 1-ethyl-cyclopropyl group, a 2-ethyl-cyclopropyl group, a n-hexyl group, a 1-methyl-n-pentyl group, a 2-methyl-n-pentyl group, a 3-methyl-n-pentyl group, a 4-methyl-n-pentyl group, a 1,1-dimethyl-n-butyl group, a 1,2-dimethyl-n-butyl group, a 1,3-dimethyl-n-butyl group, a 2,2-dimethyl-n-butyl group, a 2,3-dimethyl-n-butyl group, a 3,3-dimethyl-n-butyl group, a 1-ethyl-n-butyl group, a 2-ethyl-n-butyl group, a 1,1,2-trimethyl-n-propyl group, a 1,2,2-trimethyl-n-propyl group, a 1-ethyl-1-methyl-n-propyl group, a 1-ethyl-2-methyl-n-propyl group, a cyclohexyl group, a 1-methyl-cyclopentyl group, a 2-methyl-cyclopentyl group, a 3-methyl-cyclopentyl group, a 1-ethyl-cyclobutyl group, a 2-ethyl-cyclobutyl group, a 3-ethyl-cyclobutyl group, a 1,2-dimethyl-cyclobutyl group, a 1,3-dimethyl-cyclobutyl group, a 2,2-dimethyl-cyclobutyl group, a 2,3-dimethyl-cyclobutyl group, a 2,4-dimethyl-cyclobutyl group, a 3,3-dimethyl-cyclobutyl group, a 1-n-propyl-cyclopropyl group, a 2-n-propyl-cyclopropyl group, a 1-i-propyl-cyclopropyl group, a 2-i-propyl-cyclopropyl group, a 1,2,2-trimethyl-cyclopropyl group, a 1,2,3-trimethyl-cyclopropyl group, a 2,2,3-trimethyl-cyclopropyl group, a 1-ethyl-2-methyl-cyclopropyl group, a 2-ethyl-1-methyl-cyclopropyl group, a 2-ethyl-2-methyl-cyclopropyl group, a 2-ethyl-3-methyl-cyclopropyl group, a n-heptyl group, a cycloheptyl group, a norbornyl group, a n-octyl group, a cyclooctyl group, a n-nonyl group, an isobornyl group, a tricyclononyl group, a n-decyl group, an adamantyl group, and a tricyclodecyl group. Among these groups, a methyl group is preferred.

Examples of the linking group in L¹ include an ester bond (-COO-), an amide bond (-CONH-), an ether bond (-O-), an alkylene group having 1 to 6 carbon atoms, and an -R-O-group (R represents an alkylene group having 1 to 6 carbon atoms).

For example, in the vinyl-based polymer (A1), the boronic acid structure is bonded to the main chain of the vinyl-based polymer (A1) via a linking group having a structure obtained by allowing an epoxy group to react with a nucleophilic functional group.

Examples of the nucleophilic functional group include one type or two or more types selected from the group consisting of a carboxy group, a hydroxy group, an amino group, and a thiol group. The hydroxy group may be a phenolic hydroxy group, or need not be a phenolic hydroxy group.

When an epoxy group reacts with a carboxy group, the following reaction occurs to form the following structure (S1).

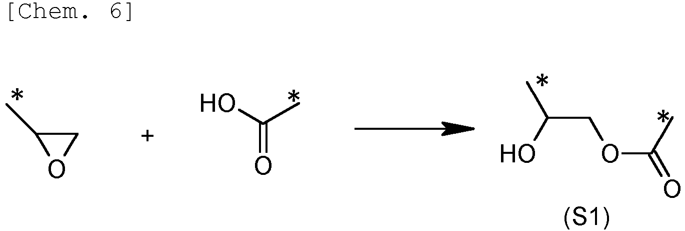

In the formulae, * represents a bond.

Further, for example, in the vinyl-based polymer (A1), the boronic acid structure is bonded to the main chain of the vinyl-based polymer (A1) via a linking group having a structure obtained by allowing an isocyanate group to react with a nucleophilic functional group. In this case, examples of the nucleophilic functional group include one type or two or more types selected from the group consisting of a hydroxy group, an amino group, and a thiol group. The hydroxy group may be a phenolic hydroxy group, or need not be a phenolic hydroxy group.

Examples of L¹ include the following linking groups (L1-1) to (L1-9).

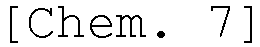

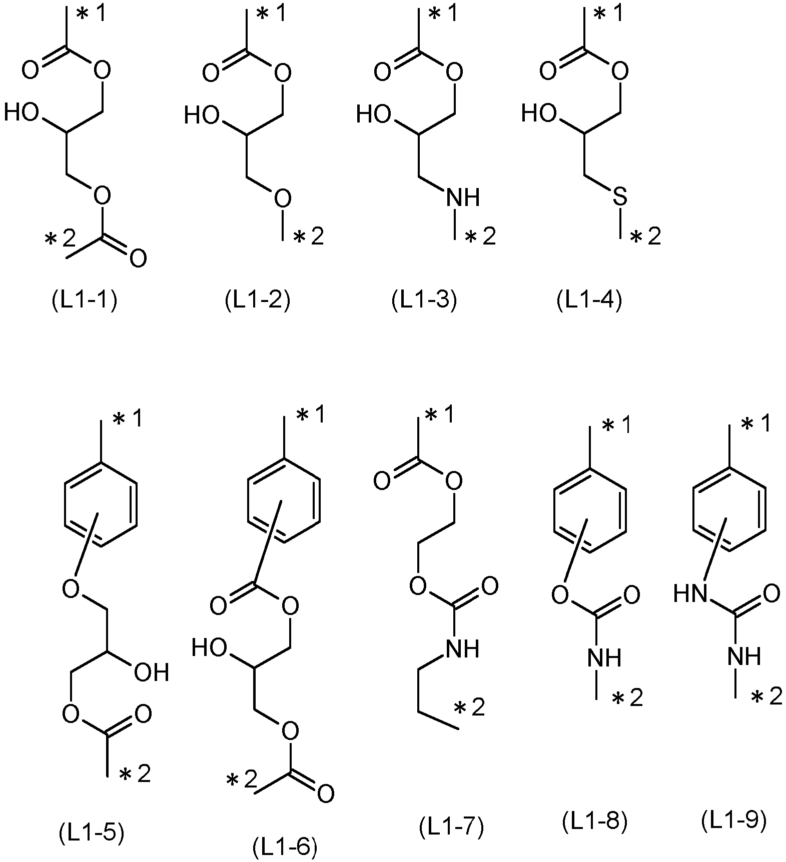

In the formulae, *1 represents a bond bonded to a carbon atom bonded to R¹¹ in formula (A1-1), and *2 represents a bond bonded to L² in formula (A1-1).

The number of carbon atoms in the divalent organic group in L² in formula (A1-1) is not particularly limited, but is preferably 1 to 10.

The divalent organic group in L² in formula (A1-1) is, for example, a hydrocarbon group, and is preferably a hydrocarbon group having 1 to 10 carbon atoms.

The divalent organic group in L² in formula (A1-1) is preferably a divalent organic group having a benzene ring bonded to B (boron) in formula (A1-1), and more preferably a phenylene group from the viewpoint of suitably obtaining the effect of the present invention.

In an example, the vinyl-based polymer (A1) containing a structural unit represented by formula (A1-1) is obtained by, for example, homopolymerizing or copolymerizing a compound having a polymerizable unsaturated bond and a boronic acid structure.

Examples of the compound having a polymerizable unsaturated bond and a boronic acid structure include compounds represented by the following formulae.

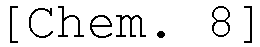

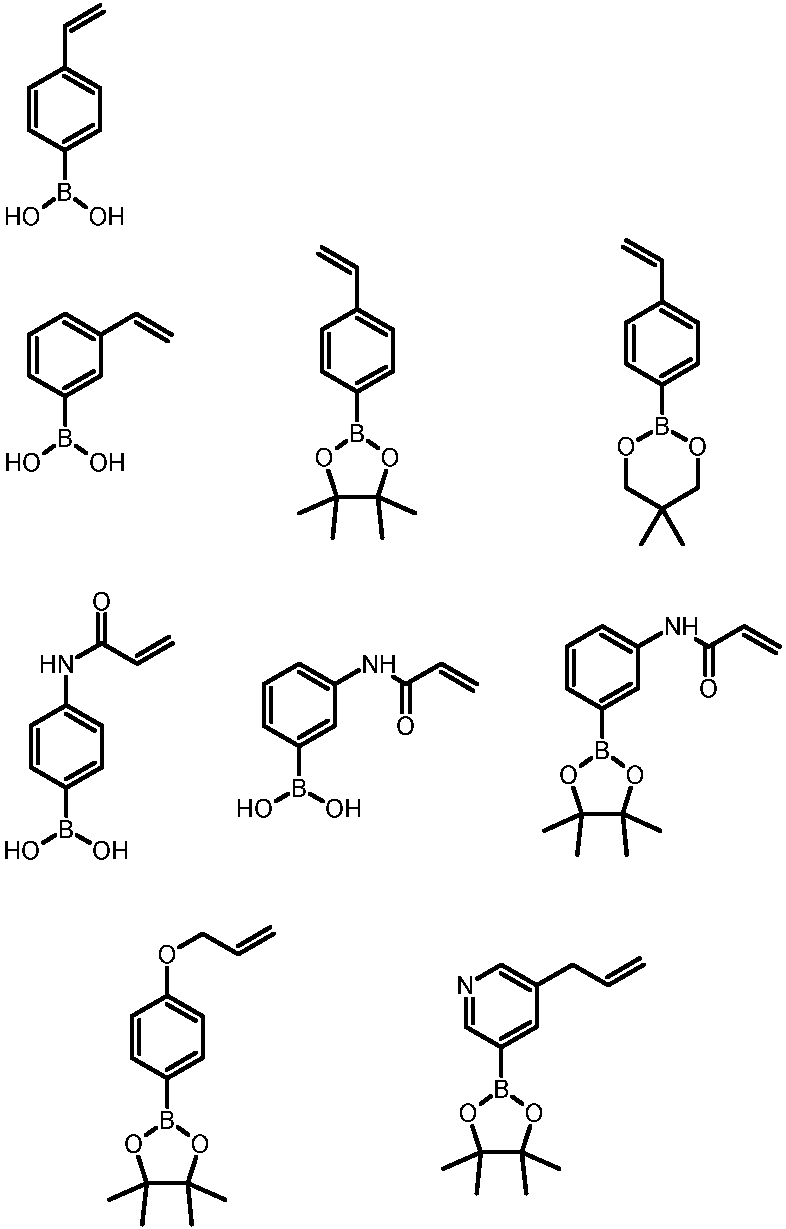

In an example, the vinyl-based polymer (A1) containing the structural unit represented by formula (A1-1) can be obtained, for example, by allowing a compound (C1) having a boronic acid structure and a carboxy group to react with a glycidyl (meth)acrylate-based polymer as described below. The glycidyl (meth)acrylate-based polymer may be a homopolymer or a copolymer. Examples of the copolymer include a copolymer of glycidyl (meth)acrylate and 2-hydroxyethyl (meth)acrylate and a copolymer of glycidyl (meth)acrylate and 2-hydroxypropyl (meth)acrylate. 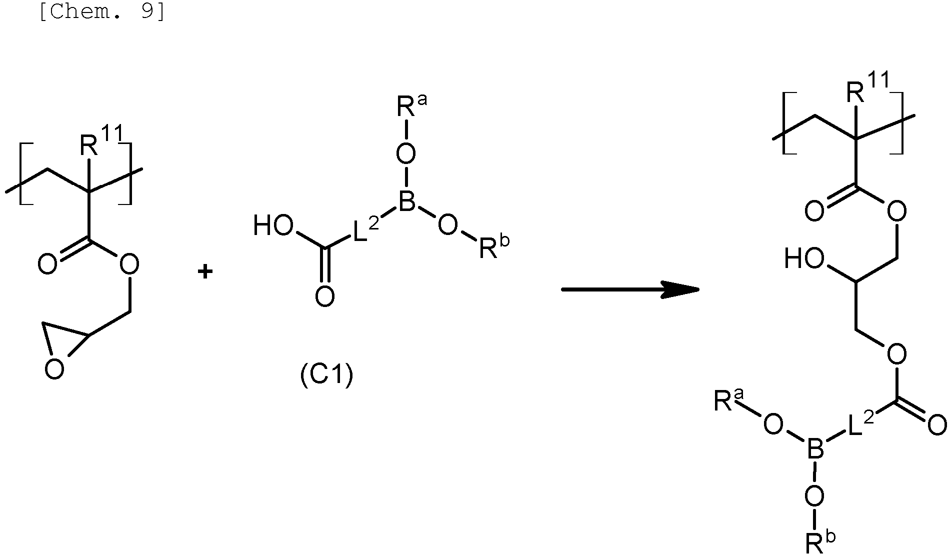 In the formulae, R¹¹, L², R^{a}, and R^{b} have the same meanings as R¹¹, L², R^{a}, and R^{b} in formula (A1-1), respectively.

The reaction can be performed, for example, in the presence of a catalyst such as tetrabutylphosphonium bromide.

Examples of the compound (C1) having a boronic acid structure and a carboxy group include the following compounds.

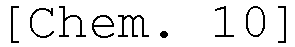

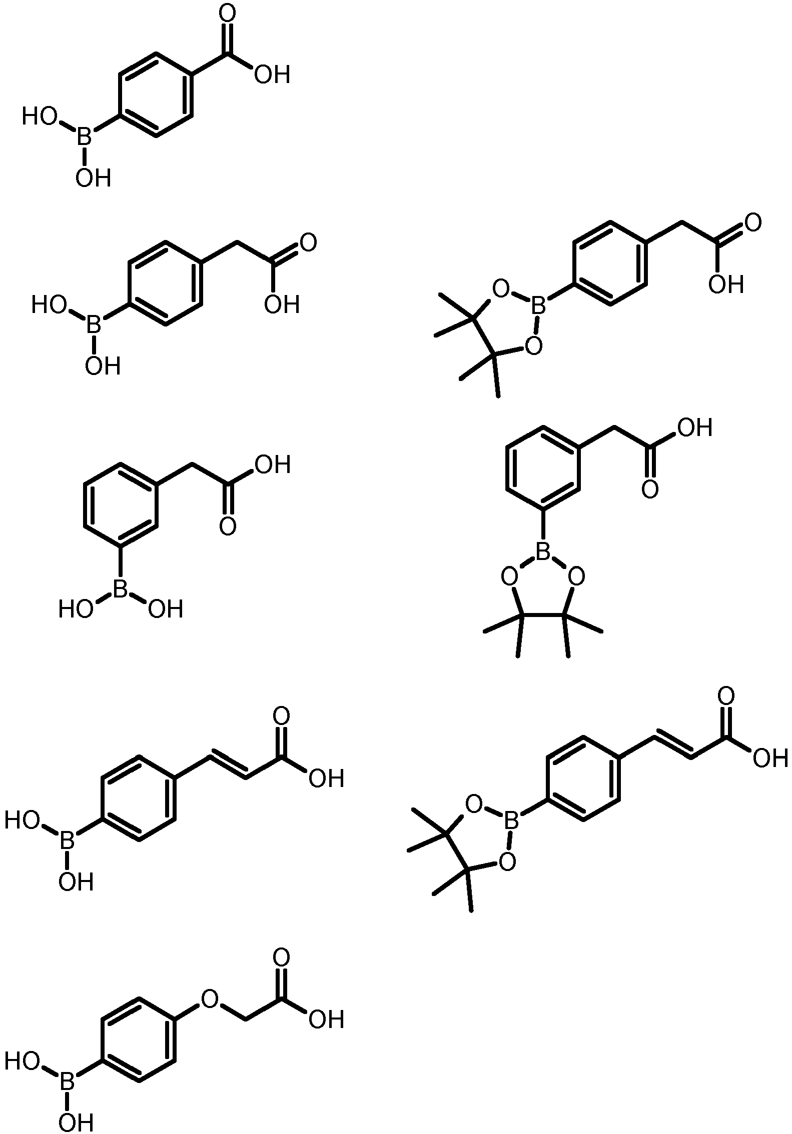

The vinyl-based polymer (A1) may have a structural unit other than the structural unit represented by formula (A1-1). Examples of such a structural unit include a structural unit represented by formula (A1-2) below and a structural unit represented by formula (A1-3) below.

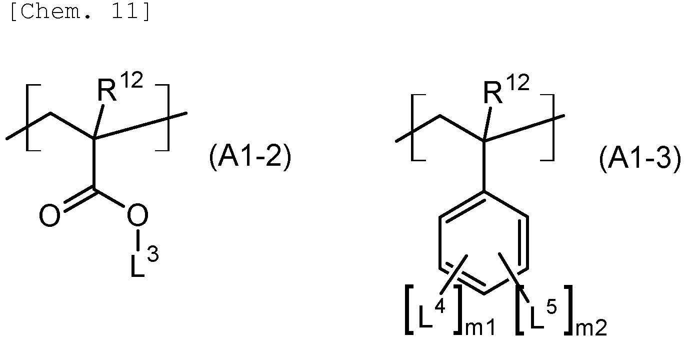

In formula (A1-2), R¹² represents a hydrogen atom or an alkyl group having 1 to 10 carbon atoms, L³ represents a monovalent organic group selected from an alkyl group having 1 to 10 carbon atoms and an aryl group having 6 to 40 carbon atoms, and at least one hydrogen atom of the alkyl group and the aryl group may be substituted with a hydroxy group.

In formula (A1-3), R¹² represents a hydrogen atom or an alkyl group having 1 to 10 carbon atoms, and L⁴ represents a hydroxy group or an amino group (-NH₂). L⁵ represents a halogen atom, an alkyl group having 1 to 6 carbon atoms, or an alkoxy group having 1 to 6 carbon atoms. m1 represents an integer of 1 to 3. m2 represents an integer of 0 to 4. However, the sum of m1 and m2 is 1 to 5; When m1 is 2 or 3, a plurality of L⁴'s may be identical or different. When m2 is 2 to 4, a plurality of L⁵'s may be identical or different.

Specific examples of the alkyl group having 1 to 10 carbon atoms represented by R¹² and the alkyl group having 1 to 10 carbon atoms represented by L³ are as described above.

Examples of the halogen atom in L⁵ include a fluorine atom, a chlorine atom, a bromine atom, and an iodine atom.

Examples of the alkyl group having 1 to 6 carbon atoms in L⁵ include a methyl group, an ethyl group, a n-propyl group, an i-propyl group, a cyclopropyl group, a n-butyl group, and an i-butyl group.

Examples of the alkoxy group having 1 to 6 carbon atoms in L⁵ include a methoxy group, an ethoxy group, a propoxy group, and a butoxy group.

Examples of the aryl group having 6 to 40 carbon atoms include a phenyl group, an o-methylphenyl group, a m-methylphenyl group, a p-methylphenyl group, an o-chlorophenyl group, a m-chlorophenyl group, a p-chlorophenyl group, an o-fluorophenyl group, a p-fluorophenyl group, an o-methoxyphenyl group, a p-methoxyphenyl group, a p-nitrophenyl group, a p-cyanophenyl group, an α-naphthyl group, a β-naphthyl group, an o-biphenylyl group, a m-biphenylyl group, a p-biphenylyl group, a 1-anthryl group, a 2-anthryl group, a 9-anthryl group, a 1-phenanthryl group, a 2-phenanthryl group, a 3-phenanthryl group, a 4-phenanthryl group, and a 9-phenanthryl group.

Examples of the monomer used to derive formula (A1-2) include the following compounds.

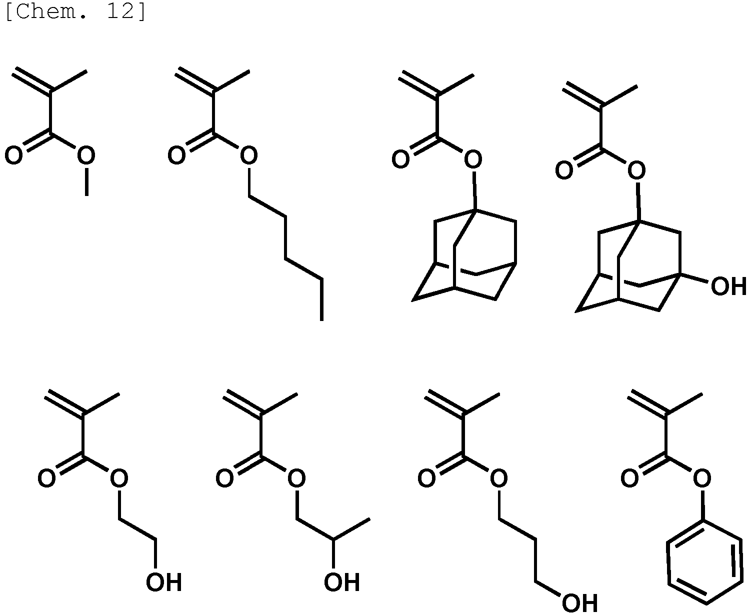

Examples of the monomer used to derive formula (A1-3) include the following compounds.

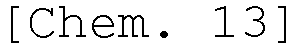

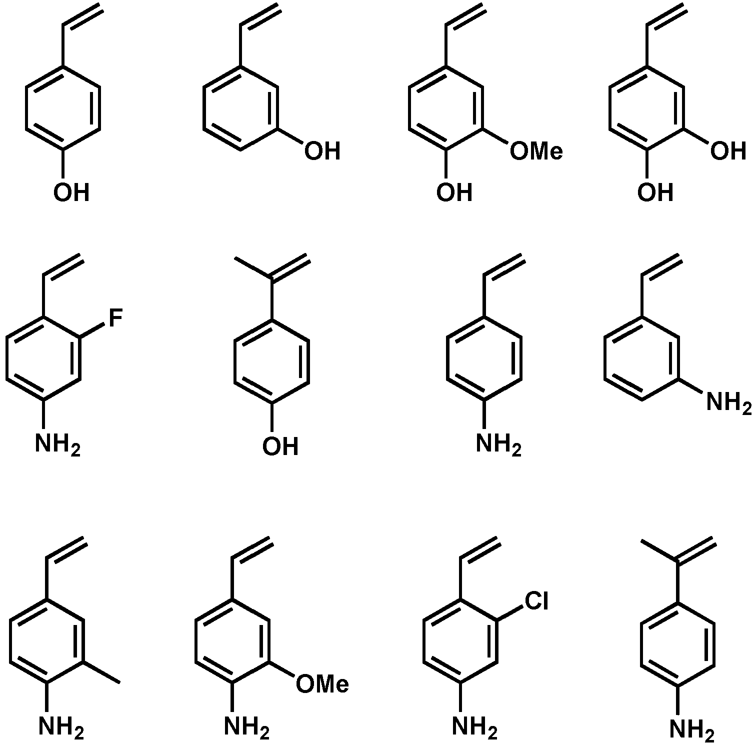

Me represents a methyl group.

The proportion of the structural unit represented by formula (A1-1) in the vinyl-based polymer (A1) is not particularly limited, and the molar ratio of the structural unit represented by formula (A1-1) may be, for example, 20 mol% to 100 mol%, or 20 mol% or more and less than 100 mol% with respect to all the structural units of the vinyl-based polymer (A1).

The proportion of the structural unit represented by formula (A1-2) in the vinyl-based polymer (A1) is not particularly limited, and the molar ratio of the structural unit represented by formula (A1-2) may be, for example, 0 mol% to 80 mol%, or more than 0 mol% and 80 mol% or less with respect to all the structural units of the vinyl-based polymer (A1).

The vinyl-based polymer (A1) may contain another structural unit other than the structural unit represented by formula (A1-1) and the structural unit represented by formula (A1-2). In that case, the molar ratio of another structural unit to all the structural units of the vinyl-based polymer (A1) is, for example, more than 0 mol% and 20 mol% or less.

### <<Polyester-based polymer (A2)>>

A case where the polymer (A) is a polyester-based polymer (A2) will be described.

The polyester-based polymer (A2) has, for example, a structure represented by formula (B1-2).

The polyester-based polymer (A2) has, for example, a structure represented by formula (A2-1) below.

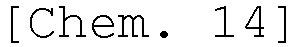

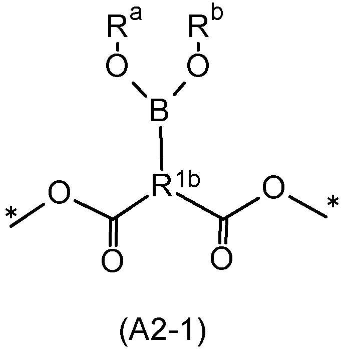

In formula (A2-1), R^{a} and R^{b} each independently represent a hydrogen atom, an alkyl group having 1 to 4 carbon atoms, a phenyl group, or a tolyl group. R^{a} and R^{b} may be combined together to form a ring structure having 3 to 6 carbon atoms.

R^{1b} represents a trivalent organic group.

* represents a bond.

From the viewpoint of suitably obtaining the effect of the present invention, R^{1b} is preferably a trivalent group obtained by removing three hydrogen atoms from a benzene ring.

The polyester-based polymer (A2) has, for example, a unit structure represented by formula (P) below.

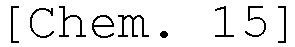

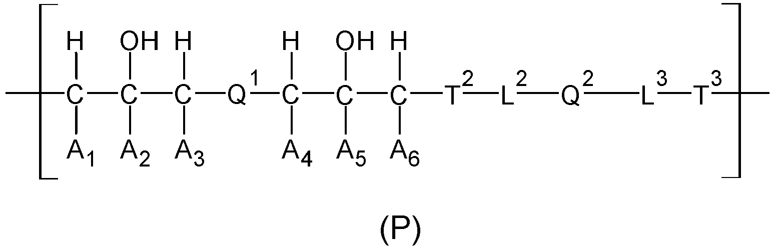

In formula (P), A₁, A₂, A₃, A₄, A₅, and A₆ each independently represent a hydrogen atom, a methyl group, or an ethyl group.

Q¹ and Q² each independently represent a divalent organic group containing a heterocyclic structure or an aromatic ring structure having 6 to 40 carbon atoms.

T² and T³ each independently represent a single bond, an ester bond, or an ether bond.

L² and L³ each independently represent a single bond, an alkylene group having 1 to 10 carbon atoms which may be substituted, or an alkenylene group having 2 to 10 carbon atoms which may be substituted.

However, at least one of Q¹ and Q² has a boronic acid structure.

Specific examples of the unit structure represented by formula (P) will be additionally described.

Examples of Q¹ include a structure represented by formula (P-1) below.

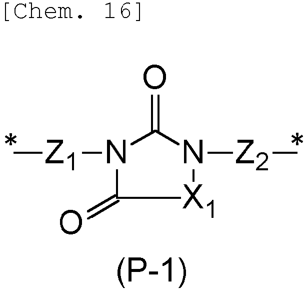

In formula (P-1), X₁ represents formula (P-1-1) below, formula (P-1-2) below, or formula (P-1-3) below.

Z₁ and Z₂ each independently represent a single bond or formula (P-1-4) below.

* represents a bond.

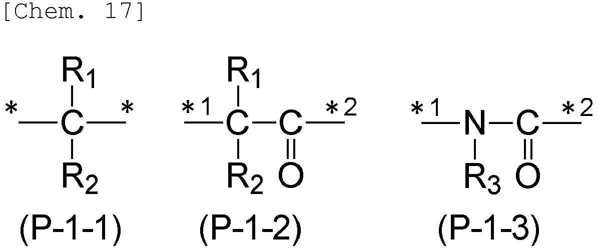

In formulae (P-1-1) and (P-1-2), R₁ and R₂ each independently represent a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, wherein the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms. R₁ and R₂ may be bonded to each other to form a ring having 3 to 6 carbon atoms. * represents a bond. *1 represents a bond bonded to a carbon atom. *2 represents a bond bonded to a nitrogen atom.

In formula (P-1-3), R₃ represents a hydrogen atom, an alkyl group having 1 to 10 carbon atoms which may be interrupted by an oxygen atom or a sulfur atom, an alkenyl group having 2 to 10 carbon atoms which may be interrupted by an oxygen atom or a sulfur atom, an alkynyl group having 2 to 10 carbon atoms which may be interrupted by an oxygen atom or a sulfur atom, a benzyl group, or a phenyl group, and the phenyl group may be substituted with at least one monovalent group selected from the group consisting of an alkyl group having 1 to 6 carbon atoms, a halogen atom, an alkoxy group having 1 to 6 carbon atoms, a nitro group, a cyano group, and an alkylthio group having 1 to 6 carbon atoms. *1 represents a bond bonded to a carbon atom. *2 represents a bond bonded to a nitrogen atom.

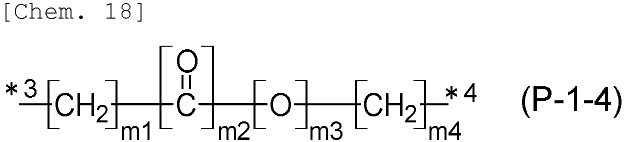

In formula (P-1-4), m1 is an integer of 0 to 4, m2 is 0 or 1, m3 is 0 or 1, and m4 is an integer of 0 to 2. However, when m3 is 1, m1 and m2 do not simultaneously become 0. *3 represents a bond bonded to a nitrogen atom in formula (P-1). *4 represents a bond.

In the present description, examples of the halogen atom include a fluorine atom, a chlorine atom, a bromine atom, and an iodine atom.

In the present description, the alkyl group is not limited to a linear alkyl group, and may be branched or cyclic. Examples of the linear or branched alkyl group include a methyl group, an ethyl group, an isopropyl group, a tert-butyl group, and a n-hexyl group. Examples of the cyclic alkyl group (cycloalkyl group) include a cyclobutyl group, a cyclopentyl group, and a cyclohexyl group.

In the present description, examples of the alkoxy group include a methoxy group, an ethoxy group, a n-pentyloxy group, and an isopropoxy group.

In the present description, examples of the alkylthio group include a methylthio group, an ethylthio group, a n-pentylthio group, and an isopropylthio group.

In the present description, examples of the alkenyl group include an ethenyl group, a 1-propenyl group, a 2-propenyl group, a 1-methyl-1-ethenyl group, a 1-butenyl group, a 2-butenyl group, a 3-butenyl group, a 2-methyl-1-propenyl group, and a 2-methyl-2-propenyl group.

In the present description, examples of the alkynyl group include a group in which a double bond of an alkenyl group listed above as the "alkenyl group" is replaced with a triple bond.

In the present description, examples of the alkenyloxy group include a vinyloxy group, a 1-propenyloxy group, a 2-n-propenyloxy group (allyloxy group), a 1-n-butenyloxy group, and a prenyloxy group.

In the present description, examples of the alkynyloxy group include a 2-propynyloxy group, a 1-methyl-2-propynyloxy group, a 2-methyl-2-propynyloxy group, a 2-butynyloxy group, and a 3-butynyloxy group.

In the present description, examples of the acyl group include an acetyl group and a propionyl group.

In the present description, examples of the aryloxy group include a phenoxy group and naphthyloxy.

In the present description, examples of the arylcarbonyl group include a phenylcarbonyl group.

In the present description, examples of the aralkyl group include a benzyl group and a phenethyl group.

In the present description, examples of the alkylene group include a methylene group, an ethylene group, a 1,3-propylene group, a 2,2-propylene group, a 1-methylethylene group, a 1,4-butylene group, a 1-ethylethylene group, a 1-methylpropylene group, a 2-methylpropylene group, a 1,5-pentylene group, a 1-methylbutylene group, a 2-methylbutylene group, a 1,1-dimethylpropylene group, a 1,2-dimethylpropylene group, a 1-ethylpropylene group, a 2-ethylpropylene group, a 1,6-hexylene group, a 1,4-cyclohexylene group, a 1,8-octylene group, a 2-ethyloctylene group, a 1,9-nonylene group, and a 1,10-decylene group.

Examples of the structure represented by formula (P-1) include the following structures.

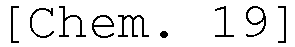

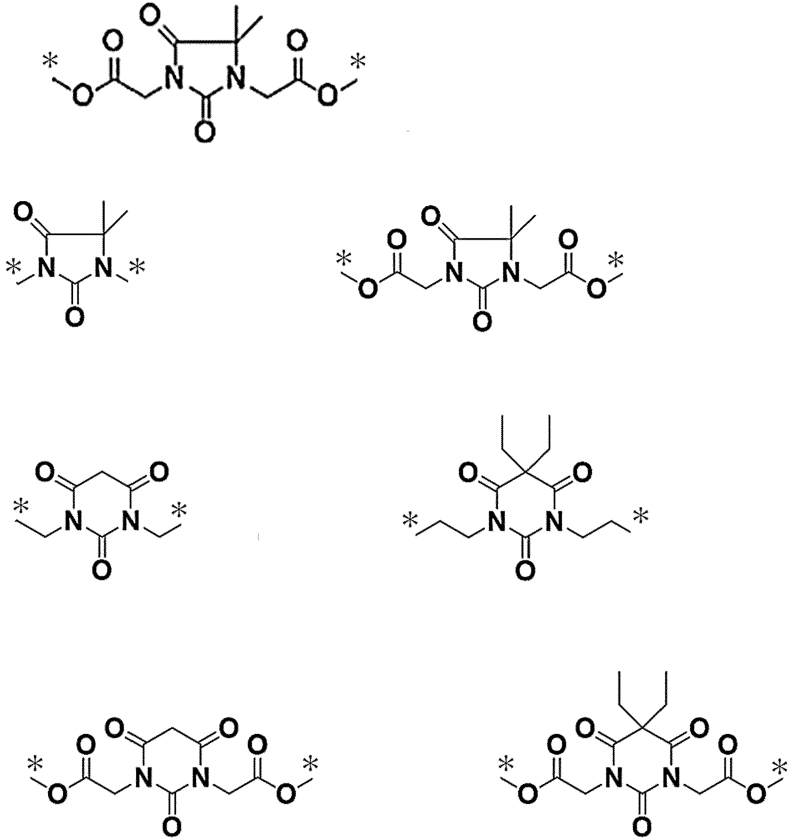

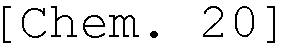

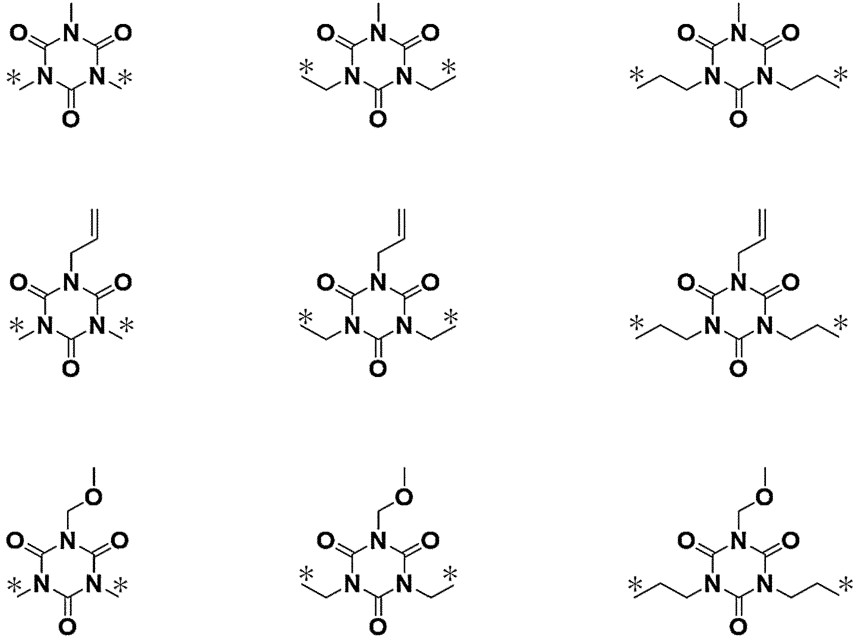

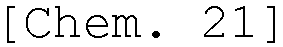

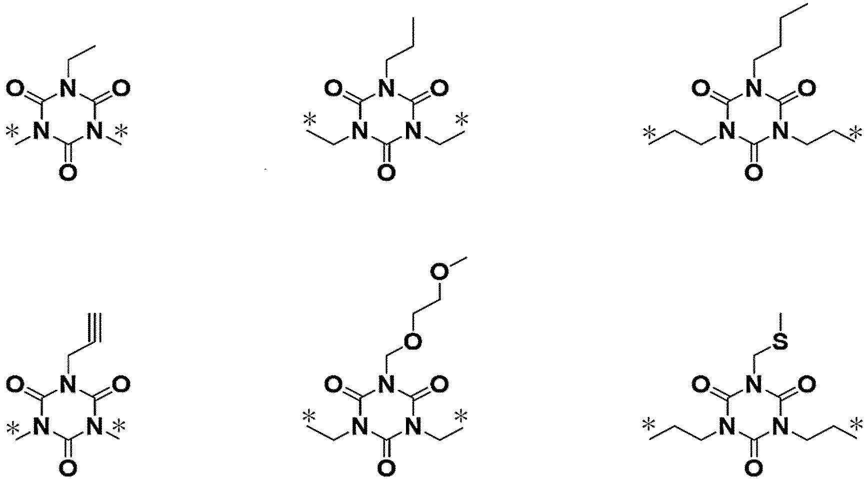

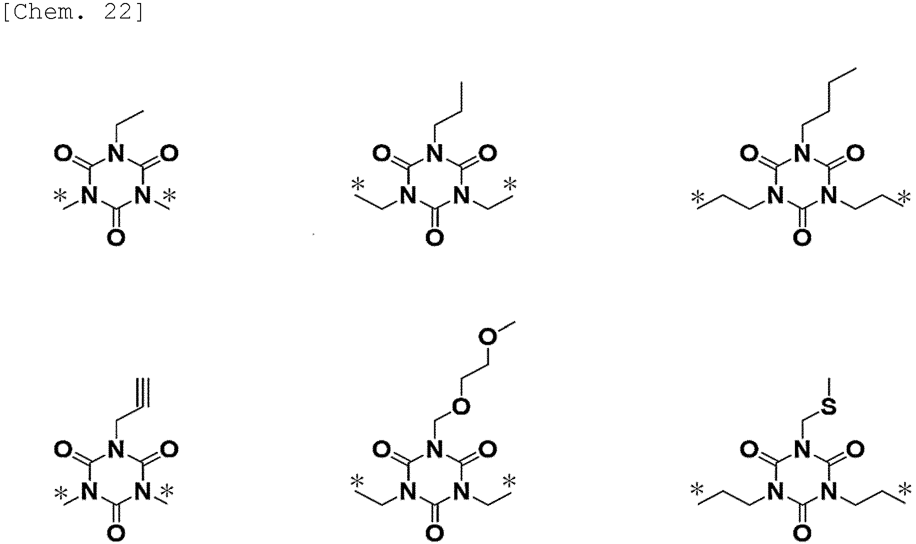

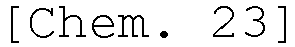

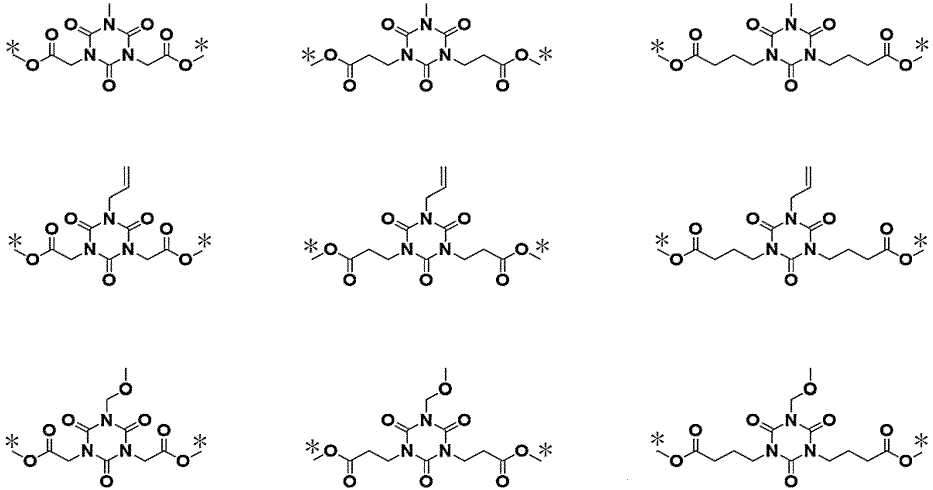

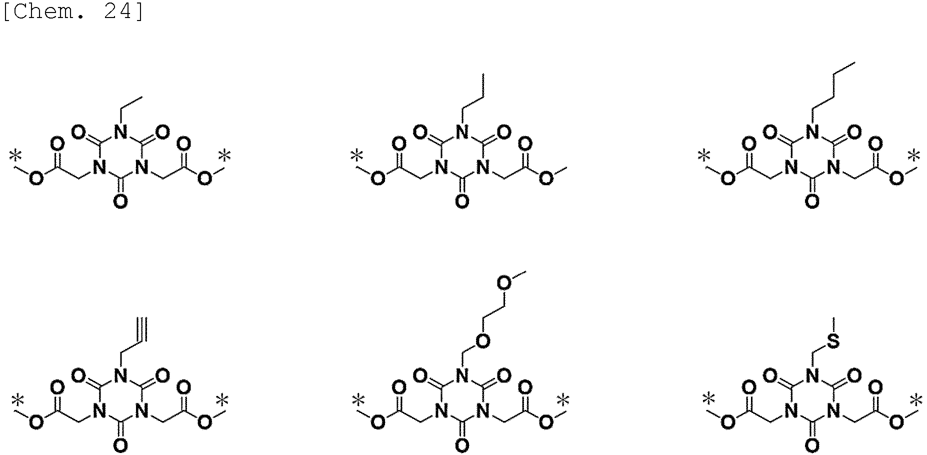

* represents a bond.

Examples of the aromatic ring having 6 to 40 carbon atoms in Q¹ and Q² include aromatic rings derived from benzene, naphthalene, anthracene, acenaphthene, fluorene, triphenylene, phenalene, phenanthrene, indene, indane, indacene, pyrene, chrysene, perylene, naphthacene, pentacene, coronene, heptacene, benzo[a]anthracene, dibenzophenanthrene, and dibenzo[a,j]anthracene. Among them, it is preferably selected from benzene, naphthalene and anthracene.

Examples of -T²-L²-Q²-L³-T³- in formula (P) include a structure represented by formula (A2-1).

The molecular weight of the polymer (A) is not particularly limited.

The lower limit of the weight average molecular weight of the polymer (A) is, for example, 500, 1,000, 2,000, or 3,000.

The upper limit of the weight average molecular weight of the polymer (A) is, for example, 30,000, 20,000, or 10,000.

The content of the polymer (A) in the resist underlayer film-forming composition is not particularly limited, and is preferably 40 mass% to 99 mass%, more preferably 45 mass% to 95 mass%, and particularly preferably 50 mass% to 90 mass% with respect to the film constituent components from the viewpoint of suitably obtaining the effect of the present invention.

In the present invention, the film constituent component means a component other than the solvent contained in the composition.

### <Solvent (B)>

The solvent (B) is not particularly limited, and may be water or an organic solvent.

Examples of the organic solvent include an alkylene glycol monoalkyl ether and a monocarboxylic acid ester of an alkylene glycol monoalkyl ether.

Examples of the alkylene group of the alkylene glycol monoalkyl ether include an alkylene group having 2 to 4 carbon atoms.

Examples of the alkyl group of the alkylene glycol monoalkyl ether include an alkyl group having 1 to 4 carbon atoms.

The number of carbon atoms of the alkylene glycol monoalkyl ether is, for example, 3 to 8.

Examples of the alkylene glycol monoalkyl ether include ethylene glycol monomethyl ether, ethylene glycol monoethyl ether, propylene glycol monomethyl ether, and propylene glycol monoethyl ether.

Examples of the alkylene group of the monocarboxylic acid ester of an alkylene glycol monoalkyl ether include an alkylene group having 2 to 4 carbon atoms.

Examples of the alkyl group of the monocarboxylic acid ester of an alkylene glycol monoalkyl ether include an alkyl group having 1 to 4 carbon atoms.

Examples of the monocarboxylic acid of the monocarboxylic acid ester of an alkylene glycol monoalkyl ether include a saturated monocarboxylic acid having 2 to 4 carbon atoms.

Examples of the saturated monocarboxylic acid having 2 to 4 carbon atoms include acetic acid, propionic acid, and butyric acid.

The number of carbon atoms of the monocarboxylic acid ester of an alkylene glycol monoalkyl ether is, for example, 5 to 10.

Examples of the monocarboxylic acid ester of an alkylene glycol monoalkyl ether include methyl cellosolve acetate, ethyl cellosolve acetate, propylene glycol monomethyl ether acetate, and propylene glycol propyl ether acetate.

Examples of other organic solvents include diethylene glycol monomethyl ether, diethylene glycol monoethyl ether, propylene glycol, toluene, xylene, methyl ethyl ketone, methyl isobutyl ketone, cyclopentanone, cyclohexanone, cycloheptanone, 4-methyl-2-pentanol, methyl 2-hydroxyisobutyrate, ethyl 2-hydroxyisobutyrate, ethyl ethoxyacetate, 2-hydroxyethyl acetate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate, 2-heptanone, methoxycyclopentane, anisole, γ-butyrolactone, N-methylpyrrolidone, N,N-dimethylformamide, and N,N-dimethylacetamide.

Among these solvents (B), an alkylene glycol monoalkyl ether and a monocarboxylic acid ester of an alkylene glycol monoalkyl ether are preferred.

One type of these solvents (B) can be used alone or two or more types thereof can be used in combination.

The mass ratio of the organic solvent in the solvent (B) is not particularly limited, but is preferably 50 mass% to 100 mass%.

The content of the solvent (B) in the resist underlayer film-forming composition is not particularly limited, and is preferably 50 mass% to 99.99 mass%, more preferably 75 mass% to 99.95 mass%, and particularly preferably 90 mass% to 99.9 mass%.

### <Crosslinking agent (C)>

The crosslinking agent (C) is not particularly limited.

The crosslinking agent (C) has a structure different from that of the polymer (A).

As the crosslinking agent (C), an aminoplast crosslinking agent and a phenoplast crosslinking agent are preferred.

The aminoplast crosslinking agent is an addition condensate of a compound having an amino group, such as melamine or guanamine, and formaldehyde.

The phenoplast crosslinking agent is an addition condensate of a compound having a phenolic hydroxy group and formaldehyde.

Examples of the crosslinking agent (C) include a compound having two or more structures shown below.

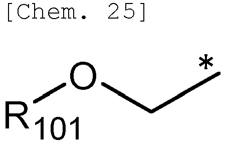

In the structure, R₁₀₁ represents a hydrogen atom, an alkyl group having 1 to 4 carbon atoms, or an alkoxyalkyl group having 2 to 6 carbon atoms. * represents a bond.

The bond is bonded to, for example, a nitrogen atom, a carbon atom included in an aromatic hydrocarbon ring, or the like.

As R₁₀₁, a hydrogen atom, a methyl group, an ethyl group, or a group represented by the following structure is preferred.

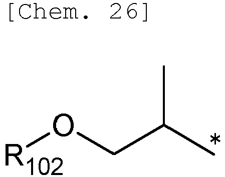

In the structure, R₁₀₂ represents a hydrogen atom, a methyl group, or an ethyl group. * represents a bond.

The crosslinking agent (C) is preferably a melamine compound, a guanamine compound, a glycoluril compound, a urea compound, or a compound having a phenolic hydroxy group. One type of these can be used alone or two or more types thereof can be used in combination.

Examples of the melamine compound include hexamethylolmelamine, hexamethoxymethylmelamine, a compound in which 1 to 6 methylol groups of hexamethylolmelamine are methoxymethylated or a mixture thereof, hexamethoxyethylmelamine, hexaacyloxymethylmelamine, and a compound in which 1 to 6 methylol groups of hexamethylolmelamine are acyloxymethylated or a mixture thereof.

Examples of the guanamine compound include tetramethylolguanamine, tetramethoxymethylguanamine, a compound in which 1 to 4 methylol groups of tetramethylolguanamine are methoxymethylated or a mixture thereof, tetramethoxyethylguanamine, tetraacyloxyguanamine, and a compound in which 1 to 4 methylol groups of tetramethylolguanamine are acyloxymethylated or a mixture thereof.

Examples of the glycoluril compound include tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof.

The glycoluril compound may be, for example, a glycoluril derivative represented by formula (1E) below.

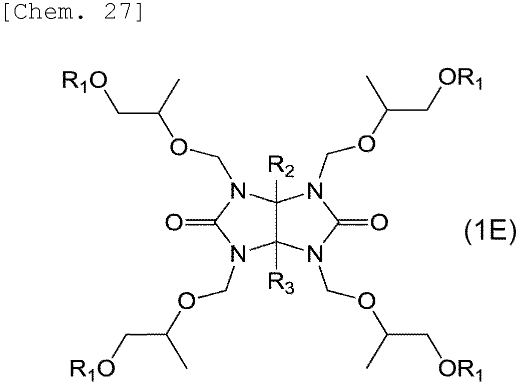

In formula (1E), four R₁'s each independently represent a methyl group or an ethyl group, and R₂ and R₃ each independently represent a hydrogen atom, an alkyl group having 1 to 4 carbon atoms, or a phenyl group.

Examples of the glycoluril derivative represented by formula (1E) include compounds represented by formulae (1E-1) to (1E-6) below.

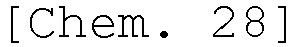

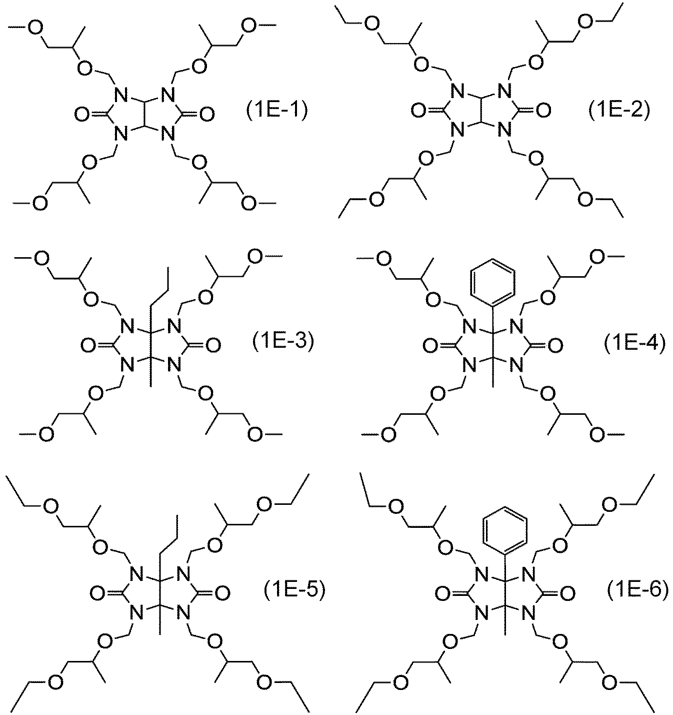

The glycoluril derivative represented by formula (1E) is obtained by, for example, allowing a glycoluril derivative represented by formula (2E) below to react with at least one type of compound represented by formula (3d) below.

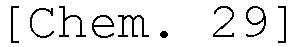

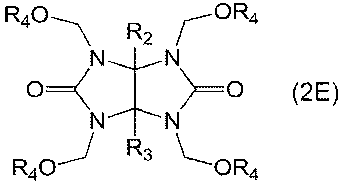

In formula (2E), R₂ and R₃ each independently represent a hydrogen atom, an alkyl group having 1 to 4 carbon atoms, or a phenyl group, and R₄'s each independently represent an alkyl group having 1 to 4 carbon atoms.

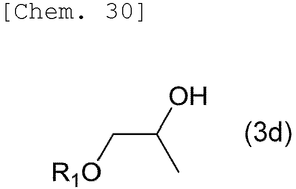

In formula (3d), R₁ represents a methyl group or an ethyl group.

Examples of the glycoluril derivative represented by formula (2E) include compounds represented by formulae (2E-1) to (2E-4) below. Examples of the compound represented by formula (3d) include compounds represented by formula (3d-1) and formula (3d-2) below.

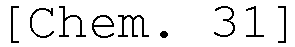

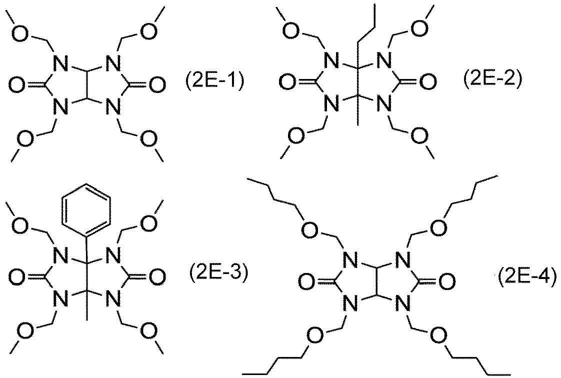

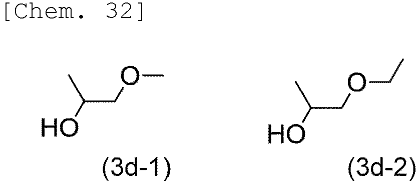

Examples of the urea compound include tetramethylol urea, tetramethoxy methyl urea, a compound in which 1 to 4 methylol groups of tetramethylol urea are methoxymethylated or a mixture thereof, and tetramethoxy ethyl urea.

Examples of the compound having a phenolic hydroxy group include a compound represented by formula (G-1) or formula (G-2) below.

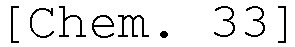

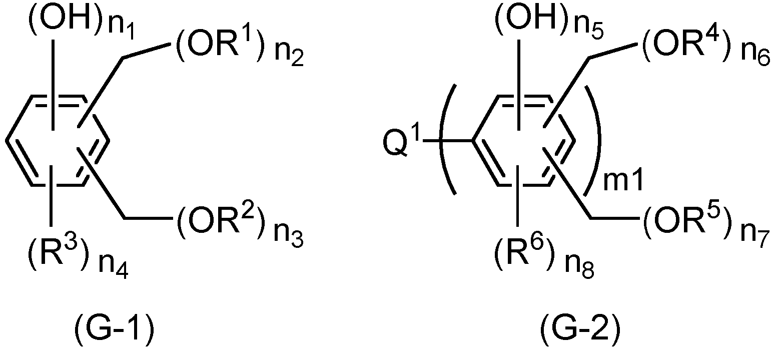

In formula (G-1) and formula (G-2), Q¹ represents a single bond or an m1-valent organic group.

R¹ and R⁴ each represent an alkyl group having 2 to 10 carbon atoms or an alkyl group having 2 to 10 carbon atoms and having an alkoxy group having 1 to 10 carbon atoms.

R² and R⁵ each represent a hydrogen atom or a methyl group.

R³ and R⁶ each represent an alkyl group having 1 to 10 carbon atoms or an aryl group having 6 to 40 carbon atoms.

n₁ represents an integer that meets 1 ≤ n₁ ≤ 3, n₂ represents an integer that meets 2 ≤ n₂ ≤ 5, n₃ represents an integer that meets 0 ≤ n₃ ≤ 3, n₄ represents an integer that meets 0 ≤ n₄ ≤ 3, and an integer that meets 3 ≤ (n₁ + n₂ + n₃ + n₄) ≤ 6.

n₅ represents an integer that meets 1 ≤ n₅ ≤ 3, n₆ represents an integer that meets 1 ≤ n₆ ≤ 4, n₇ represents an integer that meets 0 ≤ n₇ ≤ 3, n₈ represents an integer that meets 0 ≤ n₈ ≤ 3, and an integer that meets 2 ≤ (n₅ + n₆ + n₇ + n₈) ≤ 5.

m1 represents an integer of 2 to 10.

Examples of the compound having a phenolic hydroxy group include a compound represented by formula (G-3) or formula (G-4) below.

The compound represented by formula (G-1) or formula (G-2) may be obtained by a reaction of a compound represented by formula (G-3) or formula (G-4) below with a hydroxyl group-containing ether compound or an alcohol having 2 to 10 carbon atoms.

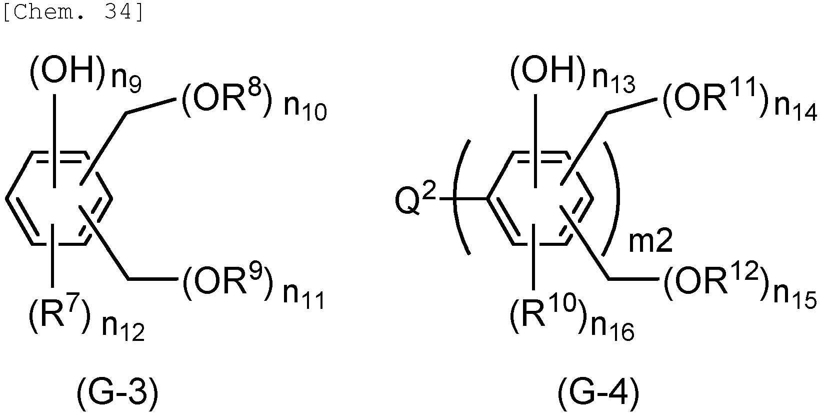

In formula (G-3) and formula (G-4), Q² represents a single bond or an m2-valent organic group.

R⁸, R⁹, R¹¹, and R¹² each represent a hydrogen atom or a methyl group.

R⁷ and R¹⁰ each represent an alkyl group having 1 to 10 carbon atoms or an aryl group having 6 to 40 carbon atoms.

n₉ represents an integer that meets 1 ≤ n₉ ≤ 3, n₁₀ represents an integer that meets 2 ≤ n₁₀ ≤ 5, n₁₁ represents an integer that meets 0 ≤ n₁₁ ≤ 3, and n₁₂ represents an integer that meets 0 ≤ n₁₂ ≤ 3, and an integer that meets 3 ≤ (n₉ + n₁₀ + n₁₁ + n₁₂) ≤ 6.

n₁₃ represents an integer that meets 1 ≤ n₁₃ ≤ 3, n₁₄ represents an integer that meets 1 ≤ n₁₄ ≤ 4, n₁₅ represents an integer that meets 0 ≤ n₁₅ ≤ 3, and n₁₆ represents an integer that meets 0 ≤ n₁₆ ≤ 3, and an integer that meets 2 ≤ (n₁₃ + n₁₄ + n₁₅ + n₁₆) ≤ 5.

m2 represents an integer of 2 to 10.

Examples of the m2-valent organic group in Q² include an m2-valent organic group having 1 to 4 carbon atoms.

Examples of the compound represented by formula (G-1) or formula (G-2) include the following compounds.

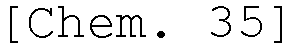

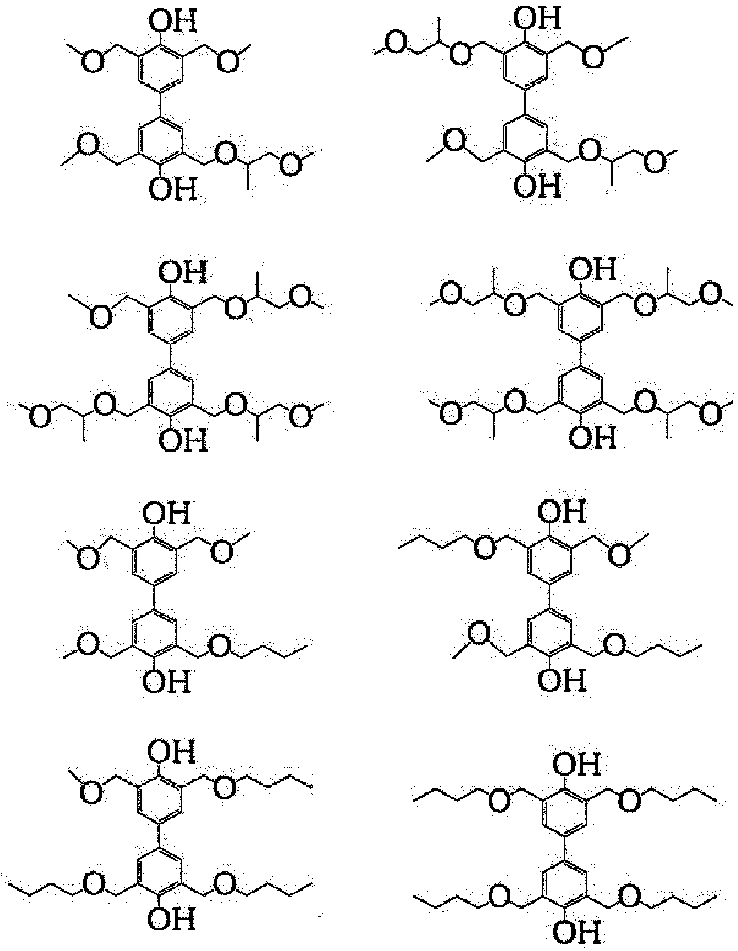

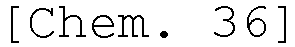

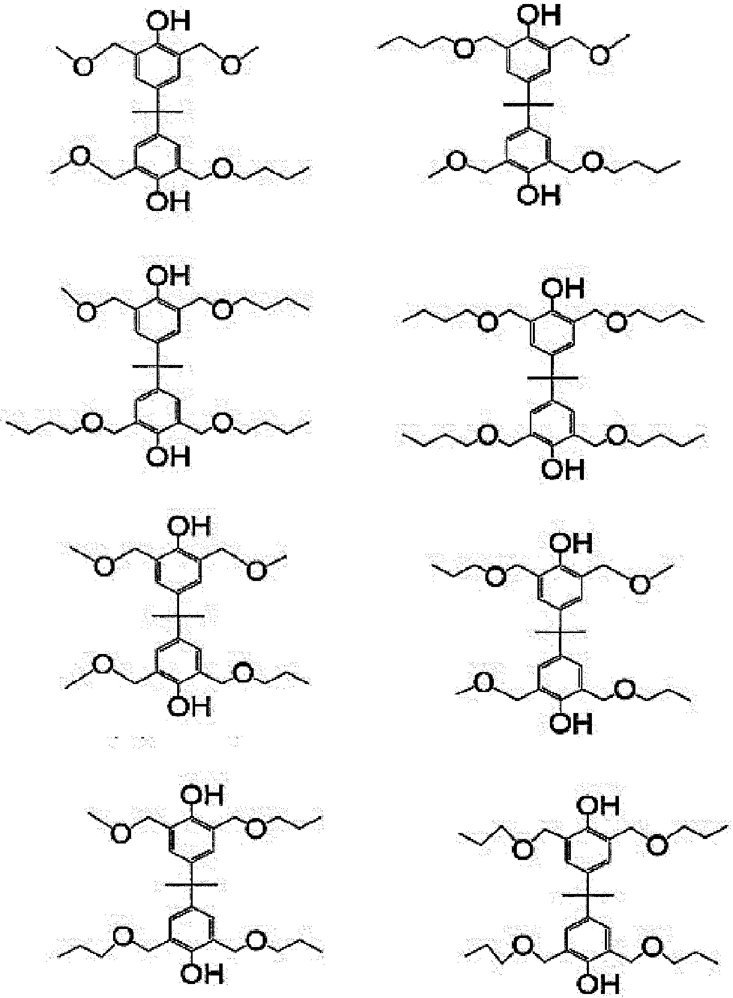

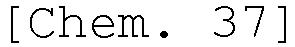

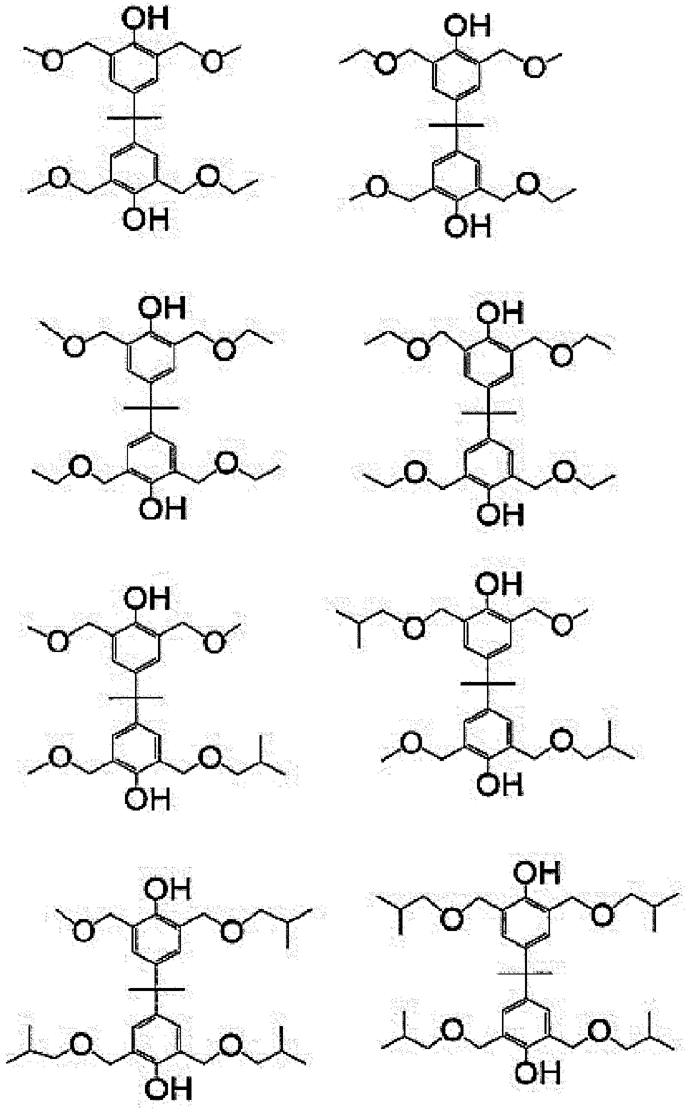

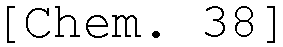

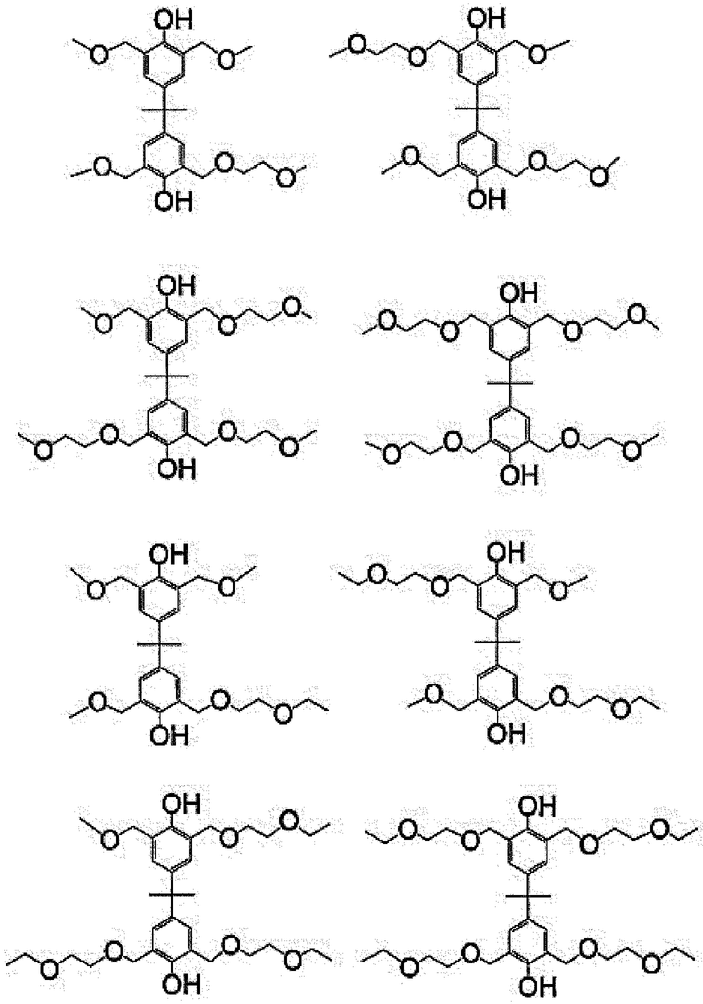

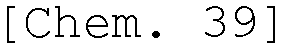

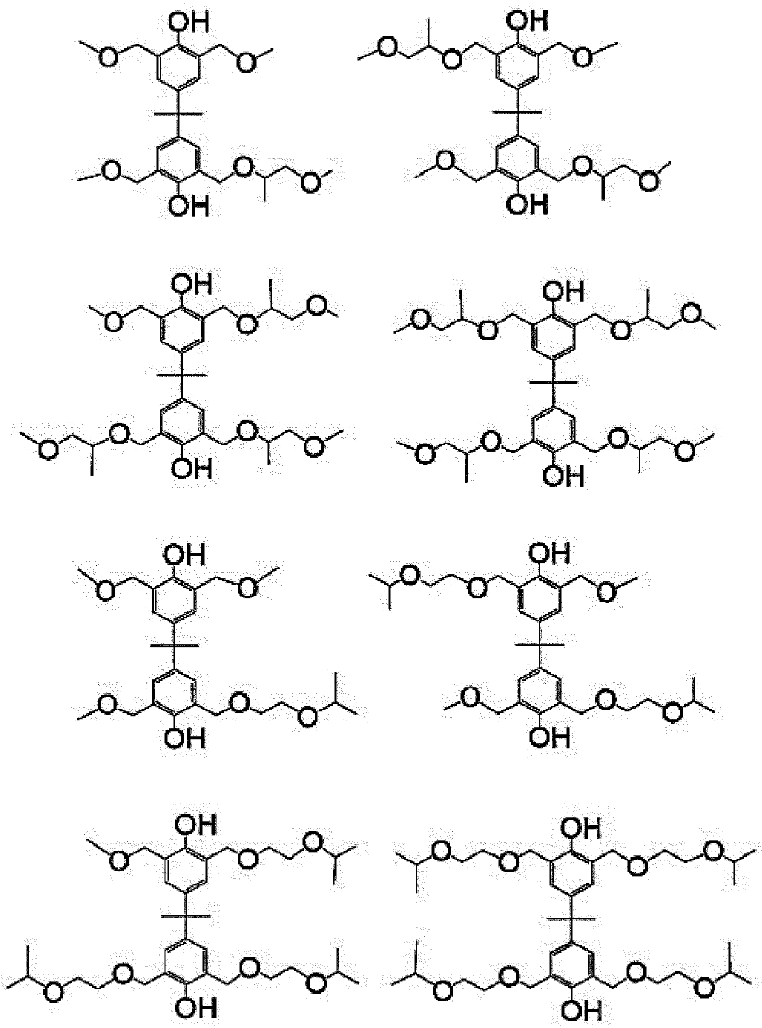

Examples of the compound represented by formula (G-3) or formula (G-4) include the following compounds.

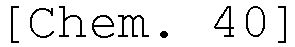

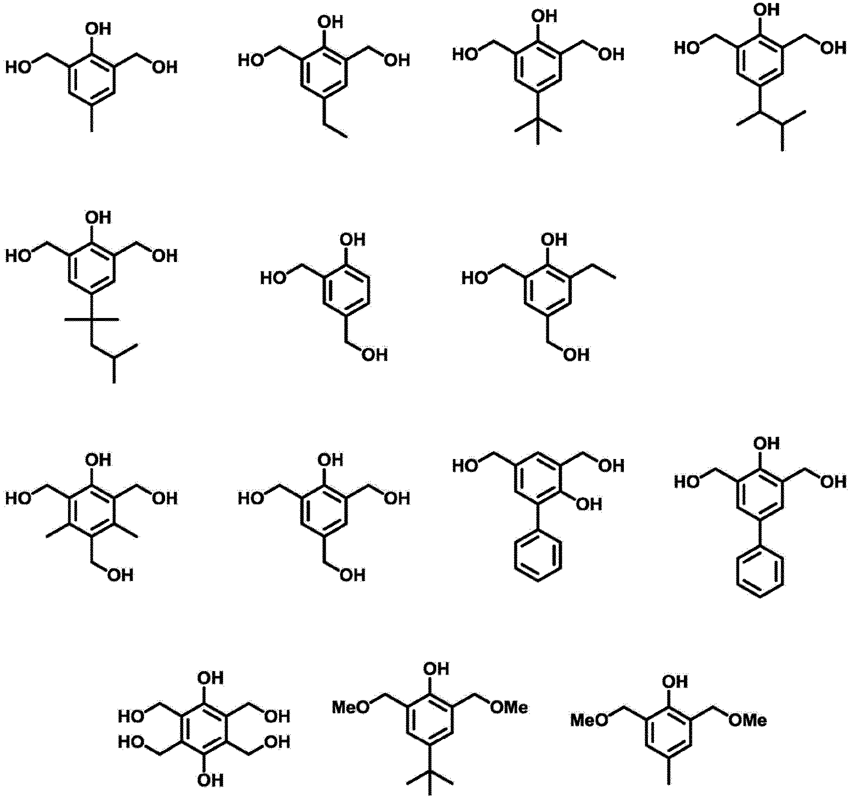

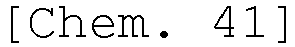

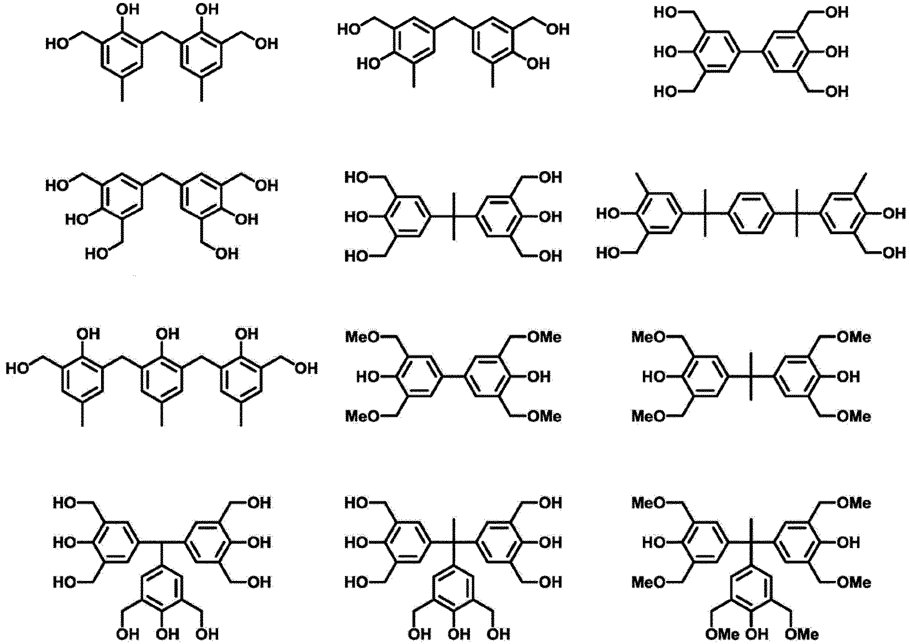

The compounds are available as products of Asahi Organic Chemicals Industry Co., Ltd. and Honshu Chemical Industry Co., Ltd. Examples of the products include TMOM-BP (trade name) manufactured by Asahi Organic Chemicals Industry Co., Ltd.

Among the compounds, the glycoluril compound is preferred. Specifically, tetramethylol glycoluril, tetramethoxy glycoluril, tetramethoxymethyl glycoluril, a compound in which 1 to 4 methylol groups of tetramethylol glycoluril are methoxymethylated or a mixture thereof, and a compound in which 1 to 4 methylol groups of tetramethylol glycoluril are acyloxymethylated or a mixture thereof are preferred, and tetramethoxymethyl glycoluril is more preferred.

The molecular weight of the crosslinking agent (C) is not particularly limited, and is preferably 500 or less.

The content of the crosslinking agent (C) in the resist underlayer film-forming composition is not particularly limited, and is, for example, 1 mass% to 70 mass%, and preferably 5 mass% to 60 mass% with respect to the polymer (A).

### <Curing catalyst (D)>

As the curing catalyst (D) contained as an optional component in the resist underlayer film-forming composition, both a thermal acid generator and a photoacid generator can be used, and a thermal acid generator is preferably used.

Examples of the thermal acid generator include sulfonic acid compounds and carboxylic acid compounds such as p-toluenesulfonic acid, trifluoromethanesulfonic acid, pyridinium p-toluenesulfonate (pyridinium p-toluenesulfonic acid), pyridinium phenolsulfonate, pyridinium p-hydroxybenzenesulfonate (p-phenolsulfonic acid pyridinium salt), pyridinium trifluoromethanesulfonate, salicylic acid, camphorsulfonic acid, 5-sulfosalicylic acid, 4-chlorobenzenesulfonic acid, 4-hydroxybenzenesulfonic acid, benzenedisulfonic acid, 1-naphthalenesulfonic acid, citric acid, benzoic acid, hydroxybenzoic acid, N-methylmorpholine p-toluenesulfonate, N-methylmorpholine p-hydroxybenzenesulfonate, and N-methylmorpholine 5-sulfosalicylate.

Examples of the photoacid generator include onium salt compounds, sulfonimide compounds, and disulfonyldiazomethane compounds.

Examples of the onium salt compounds include iodonium salt compounds such as diphenyliodonium hexafluorophosphate, diphenyliodonium trifluoromethanesulfonate, diphenyliodonium nonafluoronormalbutanesulfonate, diphenyliodonium perfluoronormaloctanesulfonate, diphenyliodonium camphorsulfonate, bis(4-tert-butylphenyl)iodonium camphorsulfonate, and bis(4-tert-butylphenyl)iodonium trifluoromethanesulfonate, and sulfonium salt compounds such as triphenylsulfonium hexafluoroantimonate, triphenylsulfonium nonafluoronormalbutanesulfonate, triphenylsulfonium camphorsulfonate, and triphenylsulfonium trifluoromethanesulfonate.

Examples of the sulfonimide compounds include N-(trifluoromethanesulfonyloxy) succinimide, N-(nonafluoronormalbutanesulfonyloxy) succinimide, N-(camphorsulfonyloxy) succinimide, and N-(trifluoromethanesulfonyloxy) naphthalimide.

Examples of the disulfonyldiazomethane compounds include bis(trifluoromethylsulfonyl)diazomethane, bis(cyclohexylsulfonyl)diazomethane, bis(phenylsulfonyl)diazomethane, bis(p-toluenesulfonyl)diazomethane, bis(2,4-dimethylbenzenesulfonyl)diazomethane, and methylsulfonyl-p-toluenesulfonyl diazomethane.

As the curing catalyst (D), only one type can be used, or two or more types can be used in combination.

In the case of using the curing catalyst (D), the content ratio of the curing catalyst (D) is, for example, 0.1 mass% to 50 mass%, and preferably 1 mass% to 30 mass% with respect to the crosslinking agent (C).

### <Other components>

In the resist underlayer film-forming composition, a surfactant can be further added in order not to generate pinholes, striation, and the like and to further improve the application property against surface irregularity.

Examples of the surfactant include nonionic surfactants including polyoxyethylene alkyl ethers such as polyoxyethylene lauryl ether, polyoxyethylene stearyl ether, polyoxyethylene cetyl ether, and polyoxyethylene oleyl ether, polyoxyethylene alkyl allyl ethers such as polyoxyethylene octylphenol ether and polyoxyethylene nonylphenol ether, polyoxyethylene-polyoxypropylene block copolymers, sorbitan fatty acid esters such as sorbitan monolaurate, sorbitan monopalmitate, sorbitan monostearate, sorbitan monooleate, sorbitan trioleate, and sorbitan tristearate, and polyoxyethylene sorbitan fatty acid esters such as polyoxyethylene sorbitan monolaurate, polyoxyethylene sorbitan monopalmitate, polyoxyethylene sorbitan monostearate, polyoxyethylene sorbitan trioleate, and polyoxyethylene sorbitan tristearate, fluorine-based surfactants such as EFTOP EF301, EF303, and EF352 (trade name, manufactured by Tochem Products Co., Ltd.), MEGAFAC F171, F173, and R-30 (trade name, manufactured by DIC Corporation), Fluorad FC430 and FC431 (trade name, manufactured by Sumitomo 3M Limited), Asahi Guard AG710, Surflon S-382, SC101, SC102, SC103, SC104, SC105, and SC106 (trade name, manufactured by AGC Corporation), and an organosiloxane polymer KP341 (manufactured by Shin-Etsu Chemical Co., Ltd.).

The blending amount of such a surfactant is usually 2.0 mass% or less, and preferably 1.0 mass% or less with respect to the total solid content of the resist underlayer film-forming composition.

These surfactants may be added alone, or two or more types thereof can also be added in combination.

The amount of the solid content in the resist underlayer film-forming composition of the present invention, that is, the components excluding the solvent is, for example, 0.01 mass% to 10 mass%.

### (Resist underlayer film)

A resist underlayer of the present invention is a cured product of the above-described resist underlayer film-forming composition.

The resist underlayer film can be produced, for example, by applying the above-described resist underlayer film-forming composition onto a semiconductor substrate and baking the composition.

Examples of the semiconductor substrate to which the resist underlayer film-forming composition is applied include a silicon wafer, a germanium wafer, and a semiconductor wafer formed of a compound such as gallium arsenide, indium phosphide, gallium nitride, indium nitride, or aluminum nitride.

When a semiconductor substrate having an inorganic film formed on a surface thereof is used, the inorganic film is formed by, for example, an atomic layer deposition (ALD) method, a chemical vapor deposition (CVD) method, a reactive sputtering method, an ion plating method, a vacuum deposition method, or a spin coating method (spin on glass: SOG). Examples of the inorganic film include a polysilicon film, a silicon oxide film, a silicon nitride film, a borophosphosilicate glass (BPSG) film, a titanium nitride film, a titanium nitride oxide film, a tungsten film, a gallium nitride film, and a gallium arsenide film.

The resist underlayer film-forming composition of the present invention is applied onto such a semiconductor substrate by an appropriate application method such as a spinner or a coater. Then, the composition is baked using a heating unit such as a hot plate to form a resist underlayer film. The baking conditions are appropriately selected from a baking temperature of 100°C to 400°C and a baking time of 0.3 minutes to 60 minutes. The baking temperature is preferably 120°C to 350°C and the baking time is preferably 0.5 minutes to 30 minutes, and the baking temperature is more preferably 150°C to 300°C, and the baking time is more preferably 0.8 minutes to 10 minutes.

The film thickness of the resist underlayer film is, for example, 0.001 µm (1 nm) to 10 µm, 0.002 µm (2 nm) to 1 µm, 0.005 µm (5 nm) to 0.5 µm (500 nm), 0.001 µm (1 nm) to 0.05 µm (50 nm), 0.002 µm (2 nm) to 0.05 µm (50 nm), 0.003 µm (3 nm) to 0.05 µm (50 nm), 0.004 µm (4 nm) to 0.05 µm (50 nm), 0.005 µm (5 nm) to 0.05 µm (50 nm), 0.003 µm (3 nm) to 0.03 µm (30 nm), 0.003 µm (3 nm) to 0.02 µm (20 nm), 0.005 µm (5 nm) to 0.02 µm (20 nm), 0.005 µm (5 nm) to 0.02 µm (20 nm), 0.003 µm (3 nm) to 0.01 µm (10 nm), 0.005 µm (5 nm) to 0.01 µm (10 nm), 0.003 µm (3 nm) to 0.006 µm (6 nm), or 0.005 µm (5 nm).

The method for measuring a film thickness of the resist underlayer film in the present description is as follows.
· Measurement apparatus name: Ellipsometric Film Thickness Measurement System RE-3100 (SCREEN Semiconductor Solutions Co., Ltd.)
· Single wavelength ellipsometer (SWE) mode
· Arithmetic average of 8 points (for example, 8 points are measured at intervals of 1 cm in X direction of wafer)

### (Laminate)

The laminate of the present invention includes a semiconductor substrate and the resist underlayer film of the present invention.

Examples of the semiconductor substrate include the semiconductor substrates described above.

The resist underlayer film is disposed, for example, on the semiconductor substrate.

### (Method for producing semiconductor element and pattern forming method)

The method for producing a semiconductor element of the present invention includes at least the following steps.
· a step of forming a resist underlayer film on a semiconductor substrate using the resist underlayer film-forming composition of the present invention
· a step of forming a resist film on the resist underlayer film

The pattern forming method of the present invention includes at least the following steps.
· a step of forming a resist underlayer film on a semiconductor substrate using the resist underlayer film-forming composition of the present invention
· a step of forming a resist film on the resist underlayer film
· a step of irradiating the resist film with light or an electron beam, and then developing the resist film to obtain a resist pattern
· a step of etching the resist underlayer film using the resist pattern as a mask

Ordinarily, a resist layer is formed on the resist underlayer film.

The film thickness of the resist layer is preferably 200 nm or less, more preferably 150 nm or less, still more preferably 100 nm or less, and particularly preferably 80 nm or less. The film thickness of the resist layer is preferably 10 nm or more, more preferably 20 nm or more, and particularly preferably 30 nm or more.

The resist formed on the resist underlayer film with a known method (such as application and baking of a resist composition) is not particularly limited as long as it responds to light or an electron beam (EB) used for irradiation. Both a negative photoresist and a positive photoresist can be used.

In the present description, a resist responding to EB is also referred to as a photoresist.

Examples of the photoresist include a positive photoresist made of a novolac resin and 1,2-naphthoquinonediazide sulfonic acid ester, a chemically amplified photoresist made of a binder having a group, which is decomposed by an acid to increase the alkali dissolution rate, and a photoacid generator, a chemically amplified photoresist made of a low molecular compound, which is decomposed by an acid to increase the alkali dissolution rate of the photoresist, an alkali-soluble binder, and a photoacid generator, a chemically amplified photoresist made of a binder having a group, which is decomposed by an acid to increase the alkali dissolution rate, a low molecular compound, which is decomposed by an acid to increase the alkali dissolution rate of the photoresist, and a photoacid generator, and a resist containing a metal element. Examples thereof include V146G (trade name) manufactured by JSR Corporation, APEX-E (trade name) manufactured by Shipley, PAR710 (trade name) manufactured by SUMITOMO CHEMICAL COMPANY, LIMITED, and AR2772 and SEPR430 (trade names) manufactured by Shin-Etsu Chemical Co., Ltd. Further, examples thereof include fluorine atom-containing polymer-based photoresists as described in Proc. SPIE, Vol. 3999, 330-334 (2000), Proc. SPIE, Vol. 3999, 357-364 (2000), and Proc. SPIE, Vol. 3999, 365-374 (2000).

So-called resist compositions such as resist compositions, radiation-sensitive resin compositions, high-resolution patterning compositions based on organometallic solutions, and metal-containing resist compositions described in WO 2019/188595 A, WO 2019/187881 A, WO 2019/187803 A, WO 2019/167737 A, WO 2019/167725 A, WO 2019/187445 A, WO 2019/167419 A, WO 2019/123842 A, WO 2019/054282 A, WO 2019/058945 A, WO 2019/058890 A, WO 2019/039290 A, WO 2019/044259 A, WO 2019/044231 A, WO 2019/026549 A, WO 2018/193954 A, WO 2019/172054 A, WO 2019/021975, WO 2018/230334 A, WO 2018/194123 A, JP 2018-180525 A, WO 2018/190088 A, JP 2018-070596 A, JP 2018-028090 A, JP 2016-153409 A, JP 2016-130240 A, JP 2016-108325 A, JP 2016-047920 A, JP 2016-035570 A, JP 2016-035567 A, JP 2016-035565 A, JP 2019-101417 A, JP 2019-117373 A, JP 2019-052294 A, JP 2019-008280 A, JP 2019-008279 A, JP 2019-003176 A, JP 2019-003175 A, JP 2018-197853 A, JP 2019-191298 A, JP 2019-061217 A, JP 2018-045152 A, JP 2018-022039 A, JP 2016-090441 A, JP 2015-10878 A, JP 2012-168279 A, JP 2012-022261 A, JP 2012-022258 A, JP 2011-043749 A, JP 2010-181857 A, JP 2010-128369 A, WO 2018/031896 A, JP 2019-113855 A, WO 2017/156388 A, WO 2017/066319 A, JP 2018-41099 A, WO 2016/065120 A, WO 2015/026482 A, JP 2016-29498 A, JP 2011-253185 A can be used, but are not limited thereto.

Examples of the resist composition include the following compositions.

An active ray-sensitive or radiation-sensitive resin composition containing a resin A having a repeating unit having an acid-decomposable group in which a polar group is protected by a protecting group to be removed by an action of an acid, and a compound represented by general formula (121) below.

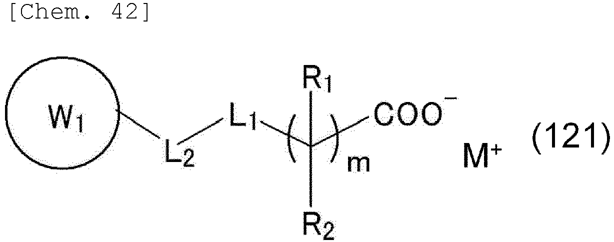

In general formula (121), m represents an integer of 1 to 6.

R₁ and R₂ each independently represent a fluorine atom or a perfluoroalkyl group.

L₁ represents -O-, -S-, -COO-, -SO₂-, or -SO₃-.

L₂ represents an alkylene group which may have a substituent, or a single bond.

W₁ represents a cyclic organic group which may have a substituent.

M⁺ represents a cation.

A metal-containing film-forming composition for extreme ultraviolet or electron beam lithography, containing a compound having a metal-oxygen covalent bond and a solvent, in which metal elements included in the compound belong to periods 3 to 7 of groups 3 to 15 in the periodic table.

A radiation-sensitive resin composition that contains a polymer having a first structural unit represented by formula (31) below and a second structural unit represented by formula (32) below and containing an acid-dissociable group, and that contains an acid generator.

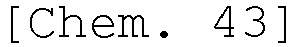

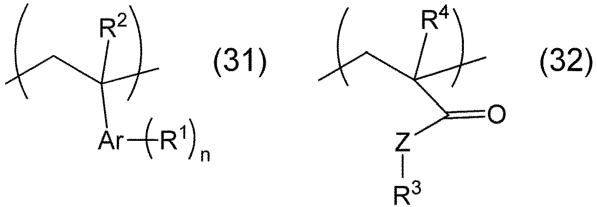

In formula (31), Ar is a group obtained by removing (n + 1) hydrogen atoms from an arene having 6 to 20 carbon atoms, R¹ is a hydroxy group, a sulfanyl group, or a monovalent organic group having 1 to 20 carbon atoms, n is an integer of 0 to 11, when n is 2 or more, a plurality of R¹'s are identical or different, and R² is a hydrogen atom, a fluorine atom, a methyl group, or a trifluoromethyl group. In formula (32), R³ is a monovalent group having 1 to 20 carbon atoms and containing the acid-dissociable group, Z is a single bond, an oxygen atom, or a sulfur atom, and R⁴ is a hydrogen atom, a fluorine atom, a methyl group, or a trifluoromethyl group.

A resist composition that contains a resin (A1) including a structural unit having a cyclic carbonate structure, a structural unit represented by the following formula, and a structural unit having an acid-unstable group, and that contains an acid generator.

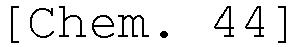

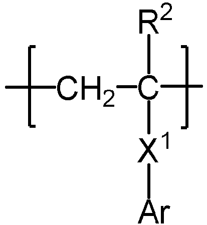

In the formula,
R² represents an alkyl group which has 1 to 6 carbon atoms and may have a halogen atom or represents a hydrogen atom or a halogen atom, X¹ represents a single bond, -CO-O-*, or -CO-NR⁴-*, * represents a bond with -Ar, R⁴ represents a hydrogen atom or an alkyl group having 1 to 4 carbon atoms, and Ar represents an aromatic hydrocarbon group which has 6 to 20 carbon atoms and may have one or more groups selected from the group consisting of a hydroxy group and a carboxy group.

Examples of the resist film include the following resist film.

A resist film including a base resin including a repeating unit represented by formula (a1) below and/or a repeating unit represented by formula (a2) below, and a repeating unit that generates an acid bonded to a polymer main chain by exposure.

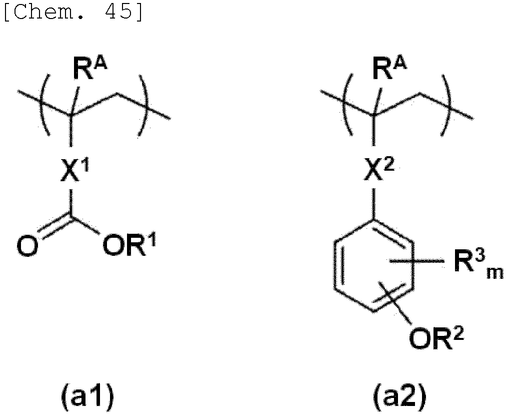

In formula (a1) and formula (a2), R^{A}'s are each independently a hydrogen atom or a methyl group, R¹ and R² are each independently a tertiary alkyl group having 4 to 6 carbon atoms, R³'s are each independently a fluorine atom or a methyl group, m is an integer of 0 to 4, X¹ is a single bond, a phenylene group, a naphthylene group, or a linking group having 1 to 12 carbon atoms and including at least one type selected from an ester bond, a lactone ring, a phenylene group, and a naphthylene group, and X² is a single bond, an ester bond, or an amide bond.

Examples of the resist material include the following resist material.

A resist material containing a polymer having a repeating unit represented by formula (b1) or formula (b2) below.

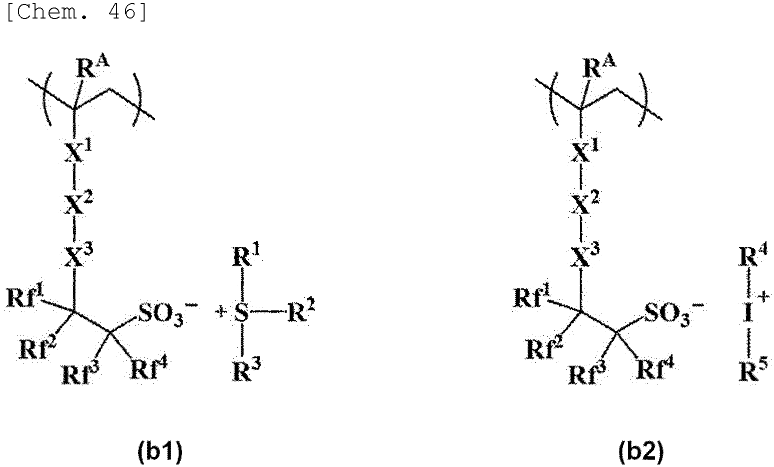

In formula (b1) and formula (b2), R^{A} is a hydrogen atom or a methyl group, X¹ is a single bond or an ester group, X² is a linear, branched, or cyclic alkylene group having 1 to 12 carbon atoms or an arylene group having 6 to 10 carbon atoms, and some of methylene groups included in the alkylene group may be substituted with an ether group, an ester group, or a lactone ring-containing group, and at least one hydrogen atom included in X² is substituted with a bromine atom, X³ is a single bond, an ether group, an ester group, or a linear, branched, or cyclic alkylene group having 1 to 12 carbon atoms, and some of methylene groups included in the alkylene group may be substituted with an ether group or an ester group, Rf¹ to Rf⁴ are each independently a hydrogen atom, a fluorine atom, or a trifluoromethyl group, and at least one of Rf¹ to Rf⁴ is a fluorine atom or a trifluoromethyl group, Rf¹ and Rf² may be combined to form a carbonyl group, R¹ to R⁵ are each independently a linear, branched, or cyclic alkyl group having 1 to 12 carbon atoms, a linear, branched, or cyclic alkenyl group having 2 to 12 carbon atoms, an alkynyl group having 2 to 12 carbon atoms, an aryl group having 6 to 20 carbon atoms, an aralkyl group having 7 to 12 carbon atoms, or an aryloxyalkyl group having 7 to 12 carbon atoms, and some or all of hydrogen atoms of these groups may be substituted with a hydroxy group, a carboxy group, a halogen atom, an oxo group, a cyano group, an amide group, a nitro group, a sultone group, a sulfone group, or a sulfonium salt-containing group, and some of methylene groups included in these groups may be substituted with an ether group, an ester group, a carbonyl group, a carbonate group, or a sulfonic acid ester group, and R¹ and R² may be bonded to form a ring together with a sulfur atom to which R¹ and R² are bonded.

A resist material containing a base resin including a polymer having a repeating unit represented by formula (a) below.

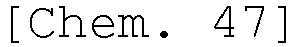

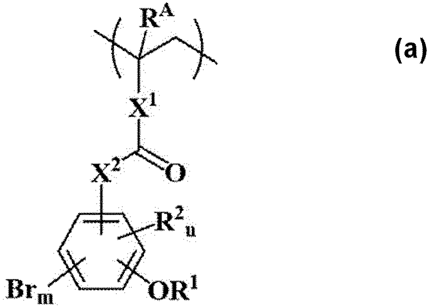

In formula (a), R^{A} is a hydrogen atom or a methyl group, R¹ is a hydrogen atom or an acid-unstable group, R² is a linear, branched, or cyclic alkyl group having 1 to 6 carbon atoms or a halogen atom other than bromine, X¹ is a single bond, a phenylene group, or a linear, branched, or cyclic alkylene group which has 1 to 12 carbon atoms and may include an ester group or a lactone ring, X² is -O-, - O-CH₂-, or -NH-, m is an integer of 1 to 4, u is an integer of 0 to 3, provided that m + u is an integer of 1 to 4.

A resist composition generating an acid by exposure and having solubility in a developer changed by an action of an acid, the resist composition containing
a base material component (A) that has a solubility in a developer changed by an action of an acid, and a fluorine additive component (F) that exhibits decomposability in an alkaline developer,
in which the fluorine additive component (F) contains a fluororesin component (F1) that has a constituent unit (f1) containing a base-dissociable group and a constituent unit (f2) containing a group represented by general formula (f2-r-1) below.

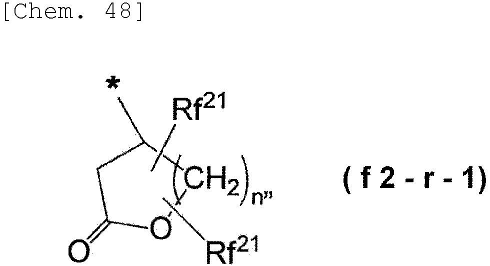

In formula (f2-r-1), Rf²¹'s are each independently a hydrogen atom, an alkyl group, an alkoxy group, a hydroxy group, a hydroxyalkyl group, or a cyano group, n" is an integer of 0 to 2, and * is a bond.

The constituent unit (f1) includes a constituent unit represented by general formula (f1-1) below or a constituent unit represented by general formula (f1-2) below.

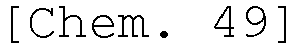

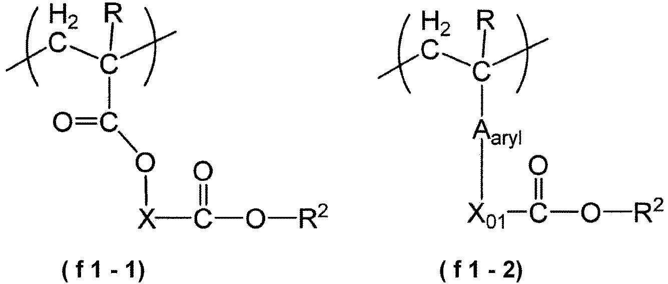

In formulae (f1-1) and (f1-2), R's are each independently a hydrogen atom, an alkyl group having 1 to 5 carbon atoms, or a halogenated alkyl group having 1 to 5 carbon atoms, X is a divalent linking group not having an acid-dissociable site, A_{aryl} is a divalent aromatic cyclic group which may have a substituent, X₀₁ is a single bond or a divalent linking group, and R²'s are each independently an organic group having a fluorine atom.

Examples of a coating, a coating solution, and a coating composition include the following.

A coating including a metal oxo-hydroxo network having an organic ligand via a metal carbon bond and/or a metal carboxylate bond.

An inorganic oxo/hydroxo-based composition.

A coating solution containing: an organic solvent; a first organometallic composition represented by the formula R_{z}SnO_{(2-(z/2)-(x/2))}(OH)ₓ (here, 0 < z ≤ 2 and 0 < (z + x) ≤ 4), the formula R'ₙSnX₄₋ₙ (here, n = 1 or 2), or a mixture thereof, wherein R and R' independently represent a hydrocarbyl group having 1 to 31 carbon atoms and X represents a ligand having a hydrolysable bond to Sn or a combination of such ligands; and a hydrolysable metal compound represented by the formula MX'ᵥ (here, M represents a metal selected from groups 2 to 16 in the periodic table, v is a number of v = 2 to 6, and X' represents a ligand having a hydrolysable M-X bond or a combination of such ligands).

A coating solution containing an organic solvent and a first organometallic compound represented by the formula RSnO_{(3/2-x/2)}(OH)ₓ (wherein 0 < x < 3) wherein the solution contains about 0.0025 M to about 1.5 M tin, R represents an alkyl group or a cycloalkyl group having 3 to 31 carbon atoms, and the alkyl group or the cycloalkyl group is bonded to tin at a secondary or tertiary carbon atom.

An inorganic pattern forming precursor aqueous solution containing a mixture of water, a metal suboxide cation, a polyatomic inorganic anion, and a radiation-sensitive ligand containing a peroxide group.

Irradiation with light or an electron beam is performed, for example, through a mask (reticle) for formation of a predetermined pattern. For example, an i-line, a KrF excimer laser, an ArF excimer laser, an extreme ultraviolet ray (EUV), or an electron beam (EB) is used. The resist underlayer film-forming composition of the present invention is preferably applied for electron beam (EB) irradiation or extreme ultraviolet ray (EUV: 13.5 nm) irradiation, and more preferably applied for extreme ultraviolet ray (EUV) exposure.

The irradiation energy of the electron beam and the exposure amount of light are not particularly limited.

Post exposure bake (PEB) may be performed after irradiation with light or an electron beam and before development.

The baking temperature is not particularly limited, and is preferably 60°C to 150°C, more preferably 70°C to 120°C, and particularly preferably 75°C to 110°C.

The baking time is not particularly limited, and is preferably 1 second to 10 minutes, more preferably 10 seconds to 5 minutes, and particularly preferably 30 seconds to 3 minutes.

In the development, for example, an alkaline developer is used.

The developing temperature is, for example, 5°C to 50°C.

The developing time is, for example, 10 seconds to 300 seconds.

As the alkaline developer, for example, an aqueous solution of an alkali such as an inorganic alkali such as sodium hydroxide, potassium hydroxide, sodium carbonate, sodium silicate, sodium metasilicate, or ammonia water, a primary amine such as ethylamine or n-propylamine, a secondary amine such as diethylamine or di-n-butylamine, a tertiary amine such as triethylamine or methyldiethylamine, an alcoholamine such as dimethylethanolamine or triethanolamine, a quaternary ammonium salt such as tetramethylammonium hydroxide, tetraethylammonium hydroxide, or choline, or a cyclic amine such as pyrrole or piperidine can be used. Further, an alcohol such as isopropyl alcohol, or a surfactant such as a nonionic surfactant can be added in an appropriate amount to the aqueous solution of an alkali and used. Among these developers, an aqueous solution of a quaternary ammonium salt is preferred, and an aqueous solution of tetramethylammonium hydroxide and an aqueous solution of choline are more preferred. Further, a surfactant or the like can also be added to these developers. It is also possible to use a method in which development is performed with an organic solvent such as butyl acetate in place of the alkaline developer and a portion where the alkali dissolution rate of the photoresist is not improved is developed.

Subsequently, the resist underlayer film is etched using the formed resist pattern as a mask. The etching may be dry etching or wet etching, and dry etching is preferred.

When the inorganic film is formed on the surface of a semiconductor substrate used, the surface of the inorganic film is exposed, and when the inorganic film is not formed on the surface of a semiconductor substrate used, the surface of the semiconductor substrate is exposed. Then, a semiconductor element can be produced through a step of processing the semiconductor substrate with a known method (dry etching method or the like).

### Examples

Next, the contents of the present invention will be specifically described with reference to examples, but the present invention is not limited thereto.

### <Measurement of molecular weight>

The weight average molecular weights of the polymers shown in the following Synthesis Examples 1 to 5, and Comparative Synthesis Examples 1 and 2 in the present description are the measurement results by gel permeation chromatography (hereinafter, abbreviated as GPC). In the measurement, a GPC apparatus manufactured by Tosoh Corporation was used, and measurement conditions and the like are as follows:
· GPC column: TSKgel Super-Multipore HZ-N (two columns)
· Column temperature: 40°C
· Solvent: tetrahydrofuran (THF)
· Flow rate: 0.35 ml/min
· Standard sample: polystyrene (manufactured by Tosoh Corporation)

### <Synthesis Example 1>

To 6.71 g of propylene glycol monomethyl ether (hereinafter abbreviated as PGME in the present description) in a reaction vessel, 18.30 g of glycidyl methacrylate-2-hydroxyethyl methacrylate copolymer (a propylene glycol monomethyl ether solution, manufactured by Osaka Organic Chemical Industry, Ltd.), 1.43 g of 4-carboxyphenylboronic acid (manufactured by Tokyo Chemical Industry Co., Ltd.), and 0.11 g of tetrabutylphosphonium bromide (manufactured by Hokko Chemical Industry Co., Ltd.) were added and dissolved therein. The reaction vessel was purged with nitrogen, and then, a reaction was allowed to proceed at 80°C for 24 hours to obtain a solution containing a polymer 1. As a result of GPC analysis, the polymer 1 obtained had a weight average molecular weight of 7,600 in terms of standard polystyrene and a dispersity of 4.2. The structure present in the polymer 1 is represented by the following formula.

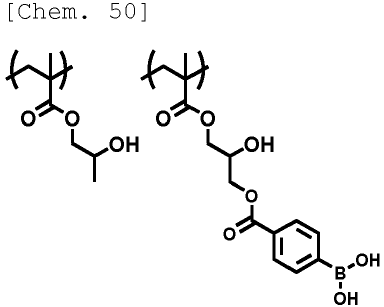

### <Synthesis Example 2>

To 14.07 g of PGME in a reaction vessel, 5.00 g of monoallyl diglycidyl isocyanurate (manufactured by Shikoku Chemicals Corporation), 3.93 g of 3,5-dicarboxyphenylboronic acid (manufactured by Tokyo Chemical Industry Co., Ltd.), and 0.45 g of tetrabutylphosphonium bromide (manufactured by Hokko Chemical Industry Co., Ltd.) were added and dissolved therein. The reaction vessel was purged with nitrogen, and then, a reaction was allowed to proceed at 140°C for 24 hours to obtain a solution containing a polymer 2. As a result of GPC analysis, the polymer 2 obtained had a weight average molecular weight of 870 in terms of standard polystyrene and a dispersity of 1.3. The structure present in the polymer 2 is represented by the following formula.

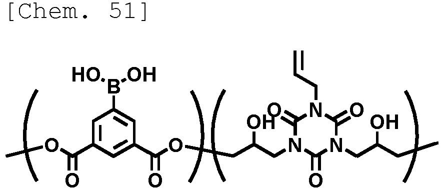

### <Synthesis Example 3>

In 13.50 g of PGME, 3.00 g of 4-vinylphenylboronic acid (manufactured by Tokyo Chemical Industry Co., Ltd.) and 0.38 g of azobisisobutyronitrile (manufactured by Tokyo Chemical Industry Co., Ltd.) were dissolved to obtain a solution. The obtained solution was added to a reaction vessel containing 5.63 g of PGME and kept at 80°C, and a reaction was allowed to proceed for 24 hours to obtain a solution containing a polymer 3. As a result of GPC analysis, the polymer 3 obtained had a weight average molecular weight of 13,300 in terms of standard polystyrene and a dispersity of 3.1. The structure present in the polymer 3 is represented by the following formula.

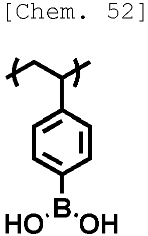

### <Synthesis Example 4>

In 19.62 g of PGME, 2.00 g of 4-vinylphenylboronic acid (manufactured by Tokyo Chemical Industry Co., Ltd.), 0.95 g of 2-hydroxyethyl methacrylate (manufactured by Tokyo Chemical Industry Co., Ltd.), and 0.52 g of azobisisobutyronitrile (manufactured by Tokyo Chemical Industry Co., Ltd.) were dissolved to obtain a solution. The obtained solution was added to a reaction vessel containing 11.54 g of PGME and kept at 60°C, and a reaction was allowed to proceed for 24 hours to obtain a solution containing a polymer 4. As a result of GPC analysis, the polymer 4 obtained had a weight average molecular weight of 16,500 in terms of standard polystyrene and a dispersity of 5.0. The structure present in the polymer 4 is represented by the following formula.

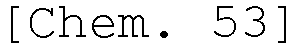

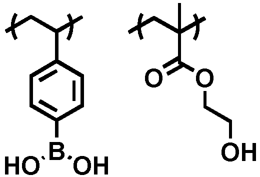

### <Synthesis Example 5>

In 25.02 g of PGME, 2.00 g of 4-vinylphenylboronic acid (manufactured by Tokyo Chemical Industry Co., Ltd.), 1.76 g of 2-hydroxyethyl methacrylate (manufactured by Tokyo Chemical Industry Co., Ltd.), and 0.66 g of azobisisobutyronitrile (manufactured by Tokyo Chemical Industry Co., Ltd.) were dissolved to obtain a solution. The obtained solution was added to a reaction vessel containing 14.72 g of PGME and kept at 60°C, and a reaction was allowed to proceed for 24 hours to obtain a solution containing a polymer 5. As a result of GPC analysis, the polymer 5 obtained had a weight average molecular weight of 25,100 in terms of standard polystyrene and a dispersity of 6.1. The structure present in the polymer 5 is represented by the following formula.

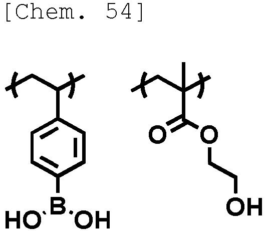

### <Comparative Synthesis Example 1>

To 682.00 g of PGME in a reaction vessel, 100.00 g of monoallyl diglycidyl isocyanurate (manufactured by Shikoku Chemicals Corporation), 66.4 g of 5,5-diethylbarbituric acid, and 4.1 g of benzyltriethylammonium chloride were added and dissolved therein. The reaction vessel was purged with nitrogen, and then a reaction was allowed to proceed at 130°C for 24 hours to obtain a solution containing a comparative polymer 1. As a result of GPC analysis, the obtained comparative polymer 1 had a weight average molecular weight of 6,800 in terms of standard polystyrene, and a dispersity of 4.8. The structure present in the comparative polymer 1 is represented by the following formula.

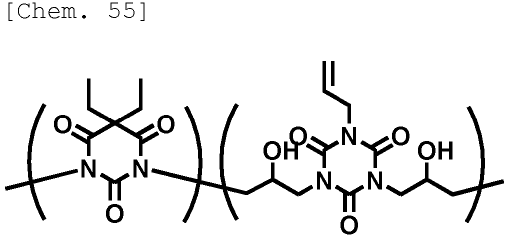

### <Comparative Synthesis Example 2>

In 20.82 g of propylene glycol monomethyl ether acetate (hereinafter abbreviated as PGMEA in the present description), 6.00 g of styrene (manufactured by Tokyo Chemical Industry Co., Ltd.), 2.50 g of 2-hydroxyethyl methacrylate (manufactured by Tokyo Chemical Industry Co., Ltd.), and 0.43 g of azobisisobutyronitrile (manufactured by Tokyo Chemical Industry Co., Ltd.) were dissolved to obtain a solution. The obtained solution was added to a reaction vessel containing 14.87 g of PGMEA and kept at 140°C, and a reaction was allowed to proceed for 24 hours to obtain a solution containing a comparative polymer 2. As a result of GPC analysis, the obtained comparative polymer 2 had a weight average molecular weight of 7,700 in terms of standard polystyrene, and a dispersity of 2.6. The structure present in the comparative polymer 2 is represented by the following formula.

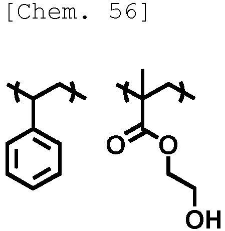

### (Preparation of resist underlayer film-forming composition)

### (Examples and Comparative Examples)

Each of the polymers obtained in Synthesis Examples 1 to 5 and Comparative Synthesis Examples 1 and 2, a crosslinking agent, a curing catalyst, and a solvent were mixed in the proportions shown in Tables 1-1 and 1-2 so that the solid content is about 0.18 mass% to 0.20 mass%, and the mixture was filtered through a 0.1 µm fluororesin filter to prepare each resist underlayer film-forming composition.

The meanings of the abbreviations in Tables 1-1 and 1-2 are as follows.
· PL-LI: tetramethoxymethyl glycoluril
· PGME-PL: Imidazo[4,5-d]imidazole-2,5(1H,3H)-dione, tetrahydro-1,3,4,6-tetrakis[(2-methoxy-1-methylethoxy)methyl]-(the following structural formula) 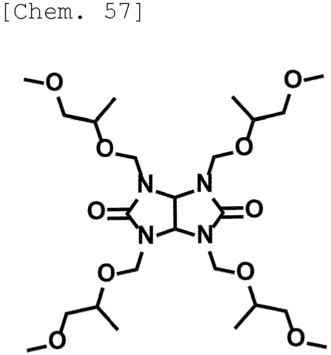
· PGME-BIP-A: Phenol, 4,4'-(1-methylethylidene)bis[2,6-bis[(2-methoxy-1-methylethoxy)methyl]-(the following formula) 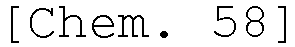 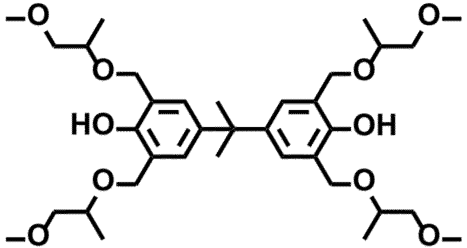
TMOM-BP: 3,3',5,5'-tetrakis(methoxymethyl)-[1,1'-biphenyl]-4,4'-diol (the following formula) 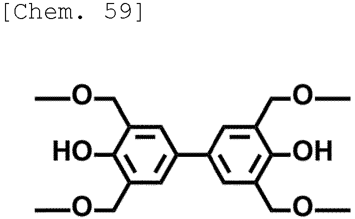
   · PyPSA: pyridinium p-hydroxybenzenesulfonate
   · R-30N: surfactant (manufactured by DIC Corporation)
   · PGMEA: propylene glycol monomethyl ether acetate
   · PGME: propylene glycol monomethyl ether

Each addition amount was expressed in parts by mass, and the solvent was expressed in composition ratio.

**[Table 1-1]**

| | Polymer | Crosslinking agent | Curing catalyst | Solvent | |
|---|---|---|---|---|---|
| Example 1 | Synthesis | PGME-PL | PyPSA | PGME | PGMEA |
| | Example 1 | | | | |
| (parts by mass) | 0.146 | 0.040 | 0.004 | 70 | 30 |
| Example 2 | Synthesis Example 2 | PGME-BIP-A | PyPSA | PGME | PGMEA |
| (parts by mass) | 0.118 | 0.059 | 0.003 | 90 | 10 |
| Example 3 | Synthesis Example 3 | TMOM-BP | PyPSA | PGME | PGMEA |
| (parts by mass) | 0.138 | 0.048 | 0.004 | 90 | 10 |
| Example 4 | Synthesis Example 4 | PGME-PL | PyPSA | PGME | PGMEA |
| (parts by mass) | 0.121 | 0.061 | 0.003 | 90 | 10 |
| Example 5 | Synthesis Example 5 | PGME-PL | PyPSA | PGME | PGMEA |
| (parts by mass) | 0.131 | 0.046 | 0.003 | 90 | 10 |
| Example 6 | Synthesis Example 5 | PGME-PL | PyPSA | PGME | PGMEA |
| (parts by mass) | 0.118 | 0.059 | 0.003 | 90 | 10 |

**[Table 1-2]**

| | Polymer | Crosslinking agent | Curing catalyst | Surfactant | Solvent | |
|---|---|---|---|---|---|---|
| Comparative Example 1 | Comparative Synthesis Example 1 | PL-LI | PyPSA | R-30N | PGME | PGMEA |
| (parts by mass) | 0.149 | 0.037 | 0.003 | 0.001 | 70 | 30 |
| Comparative Example 2 | Comparative Synthesis Example 2 | PGME-PL | PyPSA | - | PGME | PGMEA |
| (parts by mass) | 0.154 | 0.042 | 0.004 | - | 30 | 70 |

### (Elution test in photoresist solvent)

Each of the resist underlayer film-forming compositions of Examples 1 to 6 and Comparative Examples 1 and 2 was applied onto a silicon wafer using a spinner. The silicon wafer was baked at 205°C or 240°C for 60 seconds on a hot plate to obtain a film having a film thickness of 5 nm. These resist underlayer films were immersed in a mixed solution of propylene glycol monomethyl ether/propylene glycol monomethyl ether acetate = 70/30 (mass ratio), which is a solvent used for the photoresist, and a case where the film thickness change was 5 Å or less was evaluated as "good", and a case where the film thickness change was more than 5 Å was evaluated as "poor". The baking temperature and the results are shown in Table 2.

**[Table 2]**

| | Baking temperature | Elution test |
|---|---|---|
| Example 1 | 205°C | Good |
| Example 2 | 205°C | Good |
| Example 3 | 240°C | Good |
| Example 4 | 205°C | Good |
| Example 5 | 205°C | Good |
| Example 6 | 205°C | Good |
| Comparative Example 1 | 205°C | Good |
| Comparative Example 2 | 205°C | Good |

### (Evaluation of resist patterning)

### [Test of resist pattern formation by electron beam lithography system]

Each of the resist underlayer film-forming compositions of Examples 1 to 6 and Comparative Examples 1 and 2 was applied onto a silicon wafer using a spinner. The silicon wafer was baked at 205°C or 240°C for 60 seconds on a hot plate to obtain a resist underlayer film having a film thickness of 5 nm. A positive resist solution for EUV was applied onto the resist underlayer film by spin coating, followed by heating to 130°C for 60 seconds to form an EUV resist film. The resist films were exposed under the predetermined conditions using an electron beam lithography system (ELS-G130). After the exposure, the silicon wafer was baked (PEB) at 100°C for 60 seconds, cooled on a cooling plate to room temperature, and subjected to puddle developing for 30 seconds using a 2.38% aqueous tetramethylammonium hydroxide solution (trade name NMD-3 manufactured by Tokyo Ohka Kogyo Co., Ltd.) as a photoresist developer. A resist pattern having a hole size of 16 nm to 26 nm was formed. A scanning electron microscope (CG4100 manufactured by Hitachi High-Technologies Corporation) was used to measure the length of the resist pattern.

With respect to the photoresist pattern thus obtained, whether or not a contact hole (C/H) of 23 nm could be formed was checked. In all cases of Examples 1 to 6, 23 nm C/H pattern formation was observed. In addition, the charge amount at which the 23 nm contact hole was formed was defined as the optimum irradiation energy (µC/cm²). The relative value of the optimum irradiation energy when the optimum irradiation energy of Comparative Example 1 is taken as 1.00 is shown in Table 3. In Examples 1 to 6, a reduction in the optimum irradiation energy as compared with Comparative Examples 1 and 2 was observed.

**[Table 3]**

| | Baking temperature | Irradiation energy (relative value) |
|---|---|---|
| Example 1 | 205°C | 0.93 |
| Example 2 | 205°C | 0.98 |
| Example 3 | 240°C | 0.86 |
| Example 4 | 205°C | 0.85 |
| Example 5 | 205°C | 0.88 |
| Example 6 | 205°C | 0.88 |
| Comparative Example 1 | 205°C | 1.00 |
| Comparative Example 2 | 205°C | 1.02 |

## Claims

1. A resist underlayer film-forming composition, comprising a polymer (A) having a boronic acid structure and a solvent (B).

2. The resist underlayer film-forming composition according to claim 1, wherein the boronic acid structure is an arylboronic acid structure.

3. The resist underlayer film-forming composition according to claim 1, wherein the solvent (B) contains at least one type selected from a group consisting of an alkylene glycol monoalkyl ether and a monocarboxylic acid ester of an alkylene glycol monoalkyl ether.

4. The resist underlayer film-forming composition according to claim 1, further comprising a crosslinking agent (C).

5. The resist underlayer film-forming composition according to claim 4, wherein the crosslinking agent (C) is at least one type selected from a group consisting of an aminoplast crosslinking agent and a phenoplast crosslinking agent.

6. The resist underlayer film-forming composition according to claim 1, further comprising a curing catalyst (D).

7. A resist underlayer film, which is a cured product of the resist underlayer film-forming composition according to any one of claims 1 to 6.

8. A laminate, comprising:
a semiconductor substrate; and
the resist underlayer film according to claim 7.

9. A method for producing a semiconductor element, the method comprising steps of:
forming a resist underlayer film on a semiconductor substrate using the resist underlayer film-forming composition according to any one of claims 1 to 6; and
forming a resist film on the resist underlayer film.

10. A pattern forming method, comprising steps of:
forming a resist underlayer film on a semiconductor substrate using the resist underlayer film-forming composition according to any one of claims 1 to 6;
forming a resist film on the resist underlayer film;
irradiating the resist film with light or an electron beam, and then developing the resist film to obtain a resist pattern; and
etching the resist underlayer film using the resist pattern as a mask.
